# FASCICULE DE BREVET EUROPEEN

(11) **EP 3 683 949 B1**
(45) Date de publication et mention de la délivrance du brevet: **03.11.2021**
(21) Numéro de dépôt: 20151602.8
(22) Date de dépôt: 14.01.2020
(51) Int. Cl.: H02M 7/217, H02M 1/36, H02M 7/162, H02M 1/32, H02M 1/00

(54) **INTERFACE ÉLECTRONIQUE POUR RÉCUPÉRATION D'ÉNERGIE ÉLECTROMAGNETIQUE**
ELEKTRONISCHE SCHNITTSTELLE FÜR DIE ELEKTROMAGNETISCHE ENERGIERÜCKGEWINNUNG
ELECTRONIC INTERFACE FOR ELECTROMAGNETIC ENERGY HARVESTING

(30) Priorité: 16.01.2019 FR 1900375
(43) Date de publication de la demande: 22.07.2020
(73) Titulaire: Commissariat à l'énergie atomique et aux énergies alternatives, 75015 Paris (FR)
(72) Inventeur: QUELEN, Antony, 38054 Grenoble Cedex 09 (FR)
(74) Mandataire: Brevalex

(56) Documents cités:
- GYORGY D SZARKA ET AL: "Ultralow Power, Fully Autonomous Boost Rectifier for Electromagnetic Energy Harvesters", IEEE TRANSACTIONS ON POWER ELECTRONICS, INSTITUTE OF ELECTRICAL AND ELECTRONICS ENGINEERS, USA, vol. 28, no. 7, 1 juillet 2013 (2013-07-01), pages 3353-3362, XP011484359, ISSN: 0885-8993, DOI: 10.1109/TPEL.2012.2219594
- DANIEL A. SANCHEZ ET AL: "A Parallel-SSHI Rectifier for Piezoelectric Energy Harvesting of Periodic and Shock Excitations", IEEE JOURNAL OF SOLID-STATE CIRCUITS., vol. 51, no. 12, 11 novembre 2016 (2016-11-11), pages 2867-2879, XP055629086, PISCATAWAY, NJ, USA ISSN: 0018-9200, DOI: 10.1109/JSSC.2016.2615008
- GORAVANCHI PEYMAN ET AL: "On-chip AC/DC converter with no-load over-voltage protection and output ripple reduction", 2013 IEEE 18TH INTERNATIONAL WORKSHOP ON COMPUTER AIDED MODELING AND DESIGN OF COMMUNICATION LINKS AND NETWORKS (CAMAD), IEEE, 25 septembre 2013 (2013-09-25), pages 124-128, XP032541167, DOI: 10.1109/CAMAD.2013.6708102
- LEICHT JOACHIM ET AL: "A 2.6 uW-1.2 mW Autonomous Electromagnetic Vibration Energy Harvester Interface IC with Conduction-Angle-Controlled MPPT and up to 95% Efficiency", IEEE JOURNAL OF SOLID-STATE CIRCUITS, IEEE SERVICE CENTER, PISCATAWAY, NJ, USA, vol. 52, no. 9, 1 septembre 2017 (2017-09-01), pages 2448-2462, XP011659284, ISSN: 0018-9200, DOI: 10.1109/JSSC.2017.2702667 [extrait le 2017-08-23]

## Description

### DOMAINE TECHNIQUE ET ART INTERIEUR

La présente demande concerne le domaine de la récupération d'énergie électromagnétique et trouve notamment des applications dans les systèmes dits « autonomes » en énergie tels que les interrupteurs sans fil.

Elle vise plus particulièrement une architecture électronique d'interface entre un étage récupérateur d'énergie électromagnétique destiné à produire un signal AC et un étage de charge doté d'un moyen permettant de stocker cette énergie à partir d'un signal DC.

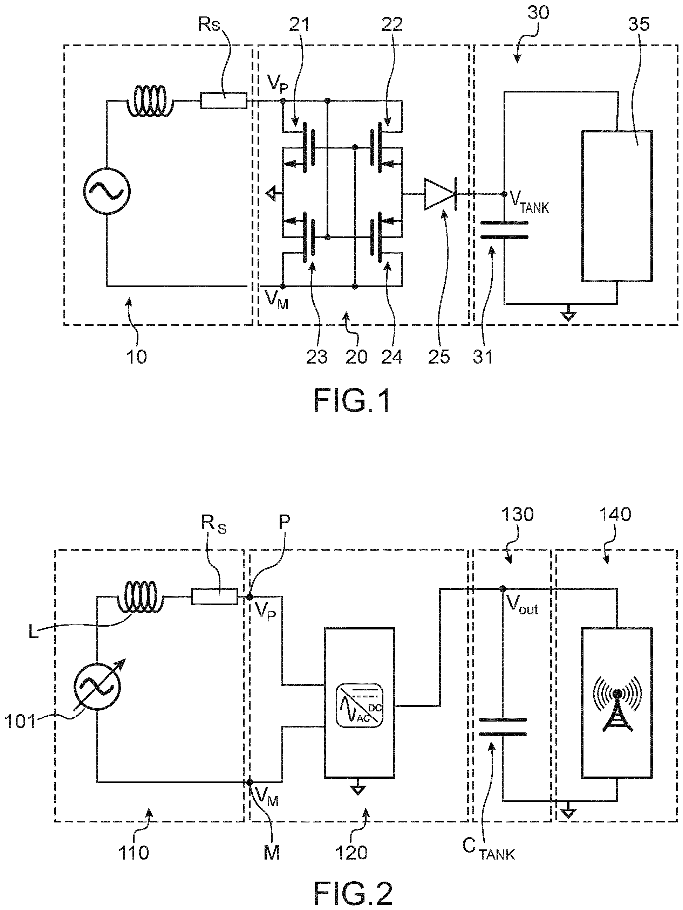

Un exemple de circuit 20 conventionnel faisant l'interface entre un étage 10 de récupération d'énergie électromagnétique et un étage de charge 30 dans un système d'interrupteur sans fil est donné sur la figure 1. L'étage de charge 30 est ici formé d'une capacité 31 associée à un émetteur RF 35.

Le circuit d'interface 20 est doté d'un convertisseur AC/DC formé de quatre transistors 21, 22, 23, 24, agencés en pont, et qui permet de redresser un courant alternatif en courant continu. En sortie du convertisseur 20, une diode 25 est typiquement prévue pour empêcher un retour de courant vers l'étage 10 de récupération d'énergie.

Un tel circuit a l'avantage d'être peu couteux à mettre en œuvre mais a un rendement énergétique en sortie, dans l'exemple illustré sur un nœud au potentiel V_{TANK} de l'ordre de 50% à 55% et que l'on cherche à améliorer.

Afin d'augmenter la quantité d'énergie électrique extraite du récupérateur d'énergie tout en minimisant les pertes du convertisseur AC/DC, on pourrait envisager d'utiliser un circuit d'interface de type « buck-boost » et semblable à celui décrit dans le document « A piezoelectric impact-induced vibration cantilever energy harvester from speed bump with a low-power management circuit », de Chen et al., sensors and actuators A254 (2017), prévu cependant dans ce document pour une récupération d'énergie piézoélectrique. Ce type de circuit fait notamment appel à une inductance externe qui le rend couteux.

Il se pose le problème de réaliser un nouveau circuit d'interface entre étage de récupération d'énergie électromagnétique et un étage de charge, qui ait un rendement énergétique amélioré et un coût réduit.

Les documents suivants divulguent des circuits de récupération d'énergie électromagnétique, piézoélectrique et/ou de conversion d'énergie électrique. Ces documents font donc partie de l'art antérieur relevant pour la présente invention :
G. D. Szarka, S. G. Burrow and B. H. Stark, "Ultralow Power, Fully Autonomous Boost Rectifier for Electromagnetic Energy Harvesters," in IEEE Transactions on Power Electronics, vol. 28, no. 7, pp. 3353-3362, July 2013, doi: 10.1109/TPEL.2012.2219594.D.
A. Sanchez, J. Leicht, F. Hagedorn, E. Jodka, E. Fazel and Y. Manoli, "A Parallel-SSHI Rectifier for Piezoelectric Energy Harvesting of Periodic and Shock Excitations," in IEEE Journal of Solid-State Circuits, vol. 51, no. 12, pp. 2867-2879, Dec. 2016, doi: 10.1109/JSSC.2016.2615008.
P. Goravanchi, R. Wunderlich and S. Heinen, "On-chip AC/DC converter with no-load over-voltage protection and output ripple réduction," 2013 IEEE 18th International Workshop on Computer Aided Modeling and Design of Communication Links and Networks (CAMAD), 2013, pp. 124-128, doi: 10.1109/CAMAD.2013.6708102.

### EXPOSÉ DE L'INVENTION

Un mode de réalisation de la présente invention prévoit un circuit électronique d'interface selon la revendication 1.

Le circuit d'interface alterne ainsi des configurations différentes permettant respectivement de réaliser des phases de charge et de décharge de l'inductance, sans faire appel à une inductance externe ou à une inductance connectée entre ses bornes d'entrée.

Avec un tel circuit, et un tel mode de fonctionnement on améliore le rendement énergétique tout en limitant le coût des composants.

Typiquement l'étage de récupération d'énergie électromagnétique a pour circuit électrique équivalent un générateur de tension alternative, une inductance L et une impédance de sortie Rs, le générateur produisant un signal alternatif AC résultant d'une conversion d'énergie mécanique en énergie électromagnétique.

Le circuit électronique d'interface peut en particulier comprendre en outre un étage de détection de mode de fonctionnement doté d'un comparateur pour comparer une tension de sortie V_{OUT} appliquée audit moyen de stockage de charges à une tension égale à un produit Rₘᵢₙ∗Iₛₑₙₛₑ d'un courant Iₛₑₙₛₑ délivré en sortie dudit redresseur et apte à être injecté dans ledit moyen de stockage de charges par une résistance Rₘᵢₙ de valeur prédéterminée en fonction de la valeur d'impédance de sortie Rₛ dudit étage de récupération d'énergie électromagnétique, et générer lorsque ce produit Rₘᵢₙ∗Iₛₑₙₛₑ est inférieur à la tension de sortie V_{OUT}, un signal de déclenchement V_{boost} à destination dudit bloc de contrôle logique et apte à déclencher un passage de la première configuration à ladite deuxième configuration du premier mode au deuxième mode.

Le circuit se trouve alors dans le mode de fonctionnement dit « de boost » dans lequel le circuit est apte ensuite à alterner une ou plusieurs phases dans ladite première configuration et une ou plusieurs phases dans ladite deuxième configuration.

La valeur Rₘᵢₙ dépend du type de récupérateur et est donc adaptée en fonction de l'étage de récupération d'énergie électromagnétique utilisé et de son impédance optimale Rₒₚₜ.

Un tel mode de fonctionnement permet de récupérer de l'énergie en particulier sur les alternances du signal fourni par le récupérateur en optimisant l'impédance vue du récupérateur.

Avantageusement, la résistance Rₘᵢₙ est telle que :
Rₘᵢₙ = K1∗Rs= K2∗Rₒₚₜ, avec K2<K1. Les coefficients K1 et K2 dépendent du type d'étage de récupération d'énergie électromagnétique utilisé. Le deuxième signal de commande V_{SR} peut être un signal logique dont l'état logique dépend de celui d'un signal indicateur T_{OFF} de première configuration produit par ledit bloc de contrôle logique.

Le premier signal de commande V_{MS} peut également être un signal logique dont l'état dépend de celui d'un signal indicateur T_{ON} de deuxième configuration produit par ledit bloc de contrôle logique et complémentaire du signal indicateur T_{OFF} de première configuration.

Le bloc de contrôle peut être en outre configuré pour modifier ledit signal indicateur T_{ON} de deuxième configuration logique consécutivement à une réception dudit signal de déclenchement V_{boost}, la ou les phase(s) dans ladite deuxième configuration ayant alors une durée fixée D_TON à l'issue de laquelle ledit bloc de contrôle modifie automatiquement le signal indicateur T_{ON} de deuxième configuration.

La ou les phases dans ladite première configuration ont quant à elles une durée maximale prédéterminée D_TOFFmax contrôlée par ledit bloc de contrôle et prévues au plus égales à la durée fixée D_TON.

La durée fixée D_TON de la ou des phases dans la deuxième configuration et la durée maximale prédéterminée D_TOFFmax de la ou des phases dans la première configuration peuvent être telles que : L/2Rs ≤ D_TON ≤ L/Rs.

Le choix de la valeur précise du D_TON dépend du type de récupérateur ou d'étage de récupération électromagnétique utilisé et dans le cas où cet étage permet par exemple de traduire une accélération mécanique en signal électromagnétique, de l'accélération subie par le récupérateur.

À titre d'exemple, pour un récupérateur particulier d'un système d'interrupteur sans-fil particulier on peut choisir D_TON= (4^{∗}L)/(7^{∗}Rs)D_TOFFmax.

La durée de différentes configurations est ainsi prévue de sorte à placer le dispositif dans des conditions optimales d'impédance vue par le récupérateur.

Selon un mode de réalisation, le circuit d'interface peut être doté également d'un premier bloc indicateur d'écoulement de durée, configuré pour, après un changement d'état dudit signal indicateur T_{ON} de deuxième configuration, générer après un délai prédéterminé égal à ladite durée fixée D_TON, un signal indicateur d'écoulement T_{OND} de durée de deuxième configuration à destination du bloc de contrôle de sorte à déclencher un nouveau changement d'état dudit signal indicateur T_{ON} de deuxième configuration.

Selon un mode de réalisation, le circuit d'interface peut être doté également d'un deuxième bloc indicateur d'écoulement de durée pour, après un changement d'état dudit signal indicateur T_{OFF} de première configuration, générer après un délai prédéterminé, un signal T_{OFFD} d'écoulement de durée maximale D_TOFFmax de première configuration à destination du bloc de contrôle apte à déclencher un nouveau changement d'état du signal indicateur T_{OFF} de première configuration.

Avantageusement, le circuit d'interface peut comprendre également : un étage de détection de courant minimal, en particulier muni d'un comparateur de courant, pour détecter un courant I_{SENSE} apte être délivré en entrée dudit étage de charge et à être injecté dans ledit moyen Cₜₐₙₖ de stockage de charges et lorsque ledit courant délivré en entrée dudit étage de charge passe en dessous d'un seuil I_{refmin}, générer en conséquence un signal V_{IMIN} de détection de courant minimal à destination du bloc de contrôle apte à déclencher un changement de configuration de la première configuration vers la deuxième configuration.

Selon un mode de réalisation du circuit d'interface, celui-ci peut être également doté en outre d'un étage de détection de valeur de tension de sortie minimale, en particulier muni d'un détecteur de seuil, configuré pour détecter un passage de la tension de sortie V_{OUT} appliquée au moyen de stockage de charges électriques au-dessus d'une valeur seuil et modifier lorsque cette détection est réalisée, un état logique d'un premier état vers un deuxième état d'un signal de détection de seuil Vₚₒᵣ à destination du bloc de contrôle logique, ledit bloc de contrôle étant configuré pour conditionner le déclenchement d'un passage de la première configuration à la deuxième configuration à ladite modification d'état dudit signal de détection de seuil Vₚₒᵣ.

Avantageusement, ledit bloc de contrôle est également configuré pour déclencher un passage de la deuxième configuration à la première configuration consécutivement à un changement d'état, du deuxième état vers le premier état, dudit signal de détection de seuil Vₚₒᵣ.

Selon un mode de réalisation particulier du circuit d'interface, celui-ci peut être également doté d'un autre étage de détection muni d'un comparateur, configuré pour comparer la tension de sortie V_{OUT} appliquée au moyen de stockage de charges électriques et la tension V_{NVC} en sortie du redresseur, et produire un signal de comparaison dont un état donné indique si la tension V_{NVC} en sortie du redresseur est supérieure à la tension de sortie V_{OUT} appliquée au moyen de stockage, le bloc de contrôle étant configuré pour conditionner la fermeture du premier interrupteur à un passage à l'état donné dudit signal Vᵤₚ de comparaison.

Selon un mode de réalisation avantageux du circuit d'interface, celui-ci peut comprendre en outre un étage de détection de surtensions de ladite tension V_{OUT} aux bornes dudit moyen Cₜₐₙₖ de stockage de charges, l'étage de détection de surtension étant doté d'un comparateur configuré pour comparer ladite tension V_{OUT} aux bornes dudit moyen de stockage de charges avec une tension de seuil prédéterminée V_{OVTH}, et produire un signal de détection de surtension Vov lorsque la tension de seuil prédéterminée est dépassée, le bloc de contrôle étant configuré pour, consécutivement à la réception dudit signal de détection de surtension Vov, déclencher un changement d'état dudit deuxième signal de commande V_{SR} de sorte à ouvrir le deuxième interrupteur, la réception dudit signal de détection de surtension Vov étant en outre apte à déclencher un changement d'état dudit premier signal de commande V_{MS} de sorte à fermer le premier interrupteur.

Avantageusement, le deuxième interrupteur peut comprendre un transistor avec des régions de source et de drain s'étendant dans une région dite de caisson (bulk), le dispositif comprenant en outre un circuit de sélection de potentiel de caisson (bulk) configuré pour consécutivement à la réception dudit signal de détection de surtension, sélectionner un potentiel donné, le plus élevé entre une tension V_{NVC} en sortie du redresseur appliqué à une borne dudit transistor de décharge et ladite tension de sortie V_{OUT} aux bornes dudit moyen de stockage de charges, et appliquer le potentiel donné sélectionné à ladite région de caisson (bulk) dudit transistor.

Typiquement dans la première configuration la première borne et la deuxième borne sont connectées directement l'une à l'autre par le premier interrupteur.

Ainsi, le premier interrupteur peut être avantageusement formé d'un transistor comportant une électrode directement connectée à ladite première borne et une électrode directement connectée à la deuxième borne. Le circuit d'interface est ainsi avantageusement dépourvu entre ses bornes d'entrée d'un composant supplémentaire de type inductance ou capacité.

Selon un mode de réalisation particulier, l'étage de charge peut être doté d'un émetteur RF associé au moyen de stockage de charges et prévu pour émettre un signal RF en fonction du remplissage dudit moyen de stockage de charges électriques. C'est le cas notamment lorsque l'étage de récupération et le circuit électronique d'interface font partie d'un système d'interrupteur sans fil.

Ainsi, selon un aspect particulier, la présente invention concerne un système d'interrupteur sans fil, comprenant :
- un étage de récupération d'énergie électromagnétique,
- un circuit électronique d'interface selon l'une des revendications précédentes agencé en sortie de l'étage de récupération d'énergie électromagnétique,
- un étage de charge en sortie dudit circuit électronique d'interface, l'étage de charge étant doté d'un moyen de stockage de charges électriques et d'un émetteur RF prévu pour émettre un signal RF en fonction du remplissage dudit moyen de stockage de charges électriques.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
La figure 1 sert à illustrer un exemple de système, suivant l'art antérieur, comprenant un étage de récupération d'énergie associé à un circuit de conversion conventionnel de signal alternatif en signal continu réalisant une interface avec un moyen de stockage d'énergie électrique associé à un étage émetteur RF ;
La figure 2 sert à illustrer un exemple de système, suivant un mode de réalisation de la présente invention, comprenant un circuit électronique d'interface particulier entre un étage de récupération d'énergie électromagnétique et un moyen de stockage d'énergie associé à un émetteur RF, le dispositif électronique d'interface étant conçu de sorte à pouvoir adopter plusieurs modes de fonctionnement de sorte à améliorer le rendement d'extraction d'énergie de l'étage de récupération tout en minimisant les pertes de la conversion AC/DC mise en œuvre par ce dispositif";
La figure 3 sert à illustrer un exemple de simulation de signal délivré par l'étage de récupération d'énergie électromagnétique lorsque l'impédance vue par celui-ci est optimale ;

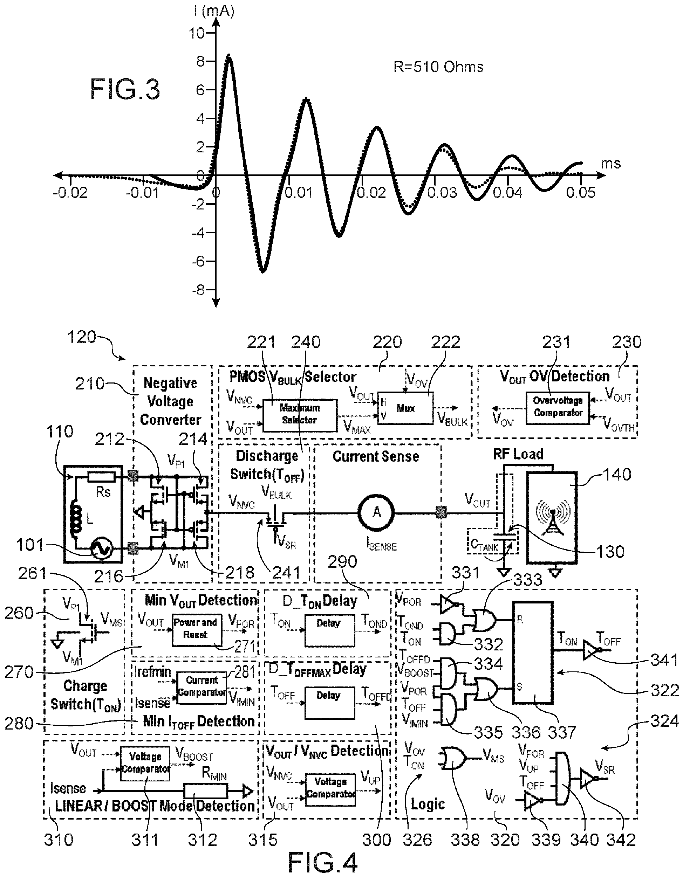

La figure 4 sert à illustrer un exemple de réalisation détaillé du dispositif électronique d'interface amené à adopter deux modes de fonctionnement, un premier mode de fonctionnement dit « linéaire » mis en œuvre pour certaines portions du signal délivré par le récupérateur d'énergie électromagnétique, et un deuxième mode de fonctionnement dit de « Boost » qui est mis en œuvre sur d'autres portions du signal délivré par le récupérateur d'énergie électromagnétique durant lequel le dispositif est susceptible d'alterner plusieurs fois entre une première configuration et une deuxième configuration ;
La figure 5 sert à illustrer un exemple d'évolution du courant de l'inductance d'un étage de récupération d'énergie associé à un circuit électronique d'interface suivant l'invention et capable d'adopter le mode de fonctionnement « linéaire » et le mode de fonctionnement « Boost » ;
La figure 6 sert à illustrer un exemple, ne relevant pas de la présente invention, de circuit électronique d'interface entre un étage de récupération d'énergie électromagnétique et un moyen de stockage d'énergie associé à un émetteur RF et doté d'une inductance externe en plus de celle de l'étage de récupération électromagnétique ;
La figure 7 sert à illustrer un exemple de réalisation particulier d'un bloc de détection de valeur minimale de la tension de sortie dans un circuit d'interface tel que mis en œuvre suivant un mode de réalisation de la présente invention ;
La figure 8 sert à illustrer un exemple de réalisation particulier d'un étage de détection de surtensions dans un circuit d'interface tel que mis en œuvre suivant un mode de réalisation de la présente invention ;
La figure 9 sert à illustrer un exemple de réalisation particulier d'un bloc indicateur d'écoulement de durée de deuxième configuration dans un circuit d'interface tel que mis en œuvre suivant un mode de réalisation de la présente invention ;
La figure 10 sert à illustrer un exemple de réalisation particulier d'un bloc indicateur d'écoulement de durée de première configuration dans un circuit d'interface tel que mis en œuvre suivant un mode de réalisation de la présente invention ;
La figure 11 sert à illustrer un exemple de réalisation particulier d'un circuit sélecteur de maximum tel que mis en œuvre dans un circuit d'interface suivant un mode de réalisation de la présente invention ;
La figure 12 sert à illustrer un exemple de réalisation particulier d'étage de détection de mode de fonctionnement tel que mis en œuvre dans un circuit d'interface suivant un mode de réalisation de la présente invention ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DETAILLÉ DE MODES DE RÉALISATION PARTICULIEURS

Un circuit électronique d'interface pour système autonome en énergie électrique va à présent être décrit en liaison avec la figure 2.

Le système comprend un premier étage 110 de récupération d'énergie électromagnétique qui est destiné à produire un signal électrique alternatif AC. Cette énergie électromagnétique résulte typiquement d'une conversion d'énergie faisant suite à une excitation mécanique. L'étage de récupération d'énergie électromagnétique comprend une inductance, c'est-à-dire doté d'au moins un composant destiné par sa construction à avoir une certaine valeur d'inductance et/ou modélisable par le biais d'un élément doté d'une inductance. Selon un exemple de réalisation particulier, peut appartenir à un système d'interrupteur sans fil. L'excitation mécanique peut dans ce cas être générée par une pression exercée sur un bouton de l'interrupteur.

Un circuit électrique équivalent de l'étage 110 de récupération d'énergie électromagnétique est représenté de manière schématique sur la figure 2, avec un générateur de tension 101 alternative, une inductance L, et une impédance de sortie Rs.

Le signal alternatif AC produit par cet étage 110 est transmis aux bornes P, M d'entrée d'un circuit électronique d'interface 120 tel que mis en œuvre suivant un mode de réalisation de la présente invention et configuré pour convertir ce signal alternatif AC en un signal DC exploitable par un étage de charge en particulier doté d'un moyen 130 de stockage d'énergie électrique. Dans l'exemple illustré, le moyen 130 de stockage d'énergie électrique comprend une capacité Cₜₐₙₖ.

La forme du signal AC délivré par l'étage 110 de récupération d'énergie électromagnétique en termes de fréquence et d'amplitude reflète celle de l'excitation. Le signal alternatif AC en entrée du circuit d'interface 120 est ainsi typiquement formé d'une succession d'oscillations. Dans le cadre notamment d'une application à un interrupteur sans fil, ces oscillations sont typiquement décroissantes.

Un exemple particulier de forme du signal alternatif AC susceptible d'être délivré en sortie du premier étage 110 est donné sur la figure 2, lorsque celui-ci voit en sortie une charge optimale Rₒₚₜ. On évalue ici la charge optimale Ropt à une résistance de l'ordre de K^{∗}Rs, avec pour un exemple de réalisation particulier associé à un type de récupérateur particulier : K=2. Sous condition de charge optimale, l'énergie extraite du récupérateur 110 est alors maximale. Le circuit électronique d'interface 120 mis en œuvre suivant l'invention est prévu pour permettre de tendre vers cette charge optimale Rₒₚₜ et pouvoir extraire un maximum d'énergie de l'étage 110 de récupération d'énergie.

Dans l'exemple de réalisation illustré, la capacité Cₜₐₙₖ, est associée à un émetteur 140 d'ondes électromagnétiques, en particulier d'ondes RF. Cet émetteur 140 RF peut être ainsi configuré pour émettre un signal RF en fonction du remplissage dudit moyen de stockage 130 indiqué par une tension de sortie V_{OUT} aux bornes de la capacité Cₜₐₙₖ.

La tension de sortie V_{OUT} du circuit d'interface 120 sous forme d'un signal DC résulte elle-même d'une conversion AC/DC dudit signal alternatif AC produit par le récupérateur 110.

Selon un exemple de réalisation particulier de l'étage émetteur 140 RF, celui-ci peut être adapté pour émettre des signaux suivant un protocole de communication de type Zigbee, c'est à dire basé sur la norme IEEE 802.15.4 et qui se rapporte aux réseaux à dimension personnelle WPAN (pour « Wireless Personal Area Networks »).

Le circuit électronique 120 d'interface pour récupérateur d'énergie électromagnétique est typiquement mis en œuvre sous forme d'un ASIC (pour « Application-Specific Integrated Circuit » autrement dit «circuit intégré propre à une application »), doté de différents blocs fonctionnels tels qu'illustrés de manière schématique sur l'exemple de réalisation donné sur la figure 4.

Le circuit électronique d'interface 120 comprend tout d'abord un convertisseur AC-DC. Le convertisseur AC-DC peut être formé d'un redresseur 210 de type pont de Graetz connecté aux bornes P1 et M1 en sortie du premier étage 110, et réalisé par un agencement en pont de quatre transistors 212, 214, 216, 218. Selon exemple de réalisation particulier illustré, le redresseur comporte 2 transistors 212, 214 à enrichissement, respectivement de type N et de type P, dotés d'une grille connectée à la borne M1 et un drain connecté à la borne P1, tandis deux autres transistors 216, 218 à enrichissement, respectivement de type N et de type P comportent une grille connectée à la borne P1 et un drain connecté à la borne M1.

Le circuit électronique 120 d'interface est, dans cet exemple de réalisation, avantageusement dépourvu d'inductance ou de capacité externe entre la sortie de l'étage de récupération 110 et le moyen de stockage 130, ce qui lui permet d'être moins encombrant et moins couteux qu'un circuit d'interface faisant appel à de tels composants.

Le circuit électronique 120 d'interface a la particularité de pouvoir adopter deux modes de fonctionnement différents.

Un premier mode de fonctionnement, que l'on appelle « linéaire », est établi notamment lorsque la capacité Cₜₐₙₖ de sortie est déchargée ou lorsque, par rapport à une tension de sortie V_{OUT} prise aux bornes de cette capacité Cₜₐₙₖ, la tension fournie par le récupérateur 110 est trop importante entre les bornes P1 et M1. Le mode de fonctionnement linéaire est privilégié en particulier sur certaines portions des premières alternances du signal AC délivré par le récupérateur 110 et consécutif dans cet exemple à un actionnement mécanique d'un élément de l'interrupteur sans fil.

Le deuxième mode de fonctionnement que l'on qualifie de « Boost » permet de réaliser une adaptation de l'impédance vue par le récupérateur 110 et de récupérer davantage d'énergie sur d'autres portions du signal AC délivré par le récupérateur 110 entre les bornes P1 et M1.

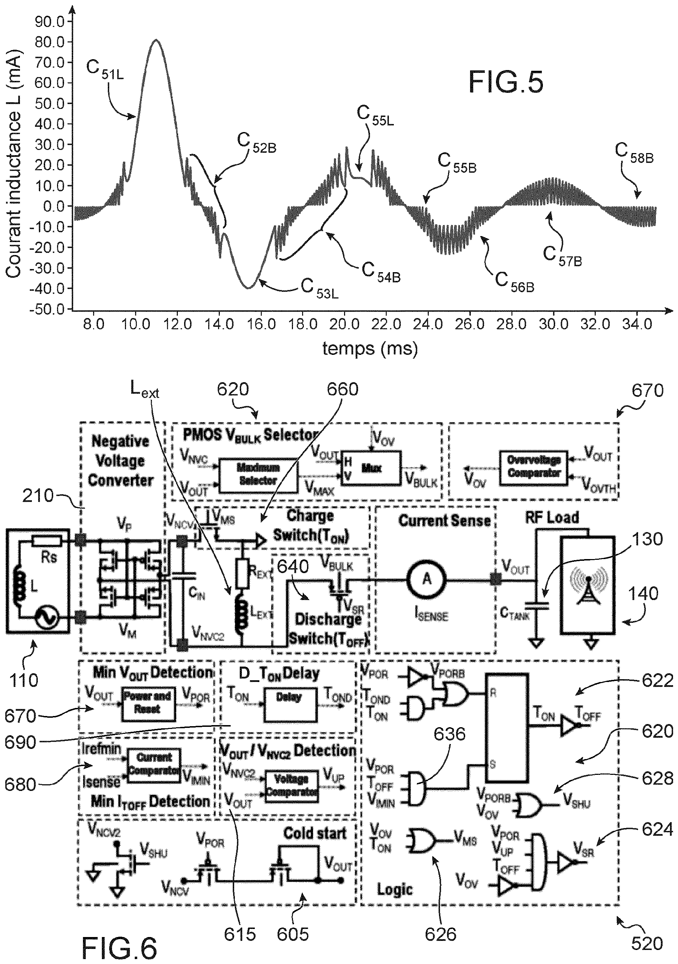

La figure 5 donne, à titre d'illustration, un exemple de courbe d'évolution, obtenue par simulation, du courant dans l'inductance L du récupérateur 110 avec une succession d'oscillations d'amplitude décroissante dont des portions correspondent alternativement au mode de fonctionnement « linéaire » (portions de courbes C_{51L}, C_{53L}, C_{55L}) et au mode de fonctionnement « Boost » (portions de courbes C_{52B}, C_{54B}, C_{55B}, C_{56B}, C_{57B}, C_{58B}) dans un cas particulier donné à titre d'exemple où la tension de sortie V_{OUT} est forcée à une valeur de 2.5V, les spires de l'inductance ont un diamètre DiamCu de 100 µm, et l'inductance a un coefficient de foisonnement kf=0.7.

Les modes de fonctionnement « linéaire » et « Boost » précités correspondent à différentes configurations d'interrupteurs du circuit 120 d'interface et en particulier d'un interrupteur 260 appelé interrupteur « de charge » et d'un interrupteur 240 appelé interrupteur « de décharge » de ce circuit.

L'interrupteur 260 de charge est disposé entre les bornes P1 et M1 d'entrée du redresseur 210 tandis que l'interrupteur 240 de décharge est disposé entre le redresseur 210 et le moyen de stockage de charges 130. L'interrupteur 260 de décharge ainsi apte à alternativement connecter ou déconnecter la borne P1 et la borne M1 l'une de l'autre, est typiquement doté ou formé d'un transistor 261, que l'on rend alternativement passant ou bloqué en fonction du niveau d'un signal de commande V_{MS} appliqué sur sa grille.

Typiquement, et comme on peut le voir sur la figure 4, le transistor 261 comporte une électrode directement connectée à la borne P1 et mise au potentiel V_{P1} et une électrode directement connectée à la borne M1 et mise au potentiel V_{M1}. Ainsi, lorsque le transistor 261 est rendu passant les bornes P1 et M1 sont connectées directement l'une à l'autre. On court-circuite ainsi les deux bornes P1 et M1 d'entrée du circuit d'interface dans la première configuration.

Dans l'exemple de réalisation illustré, le transistor 261 est un transistor de type N, dont le drain et la source sont respectivement connectées à la borne P1 et à la borne M1, et dont le caisson (également communément appelé « BODY » ou « BULK » selon la terminologie anglo-saxonne) est mis à un potentiel de référence ou de masse.

Le signal de commande V_{MS} peut être en particulier un signal logique produit par un étage 326 d'un bloc de contrôle 320 logique, autrement dit un circuit ou une portion de circuit logique.

Ce bloc de contrôle 320 comprend une pluralité d'étages 322, 324, 326, formé de composants logiques utilisés en logique combinatoire et/ou séquentielle. Les étages 324, 326 sont en particulier dotés d'une ou plusieurs portes logiques 338, 339, 340, 342, tandis que l'étage 322 est formé de portes logiques 331, 332, 333, 334, 335, 336, 341 et d'au moins un élément tel qu'une bascule 337 capable, dans certaines circonstances, de maintenir les valeurs de sa ou ses sorties malgré des changements de valeur(s) d'entrée(s).

Le signal de commande V_{MS} dont le niveau, correspondant à un état logique '0' ou '1', détermine celui, respectivement ouvert (bloqué) ou fermé (passant), de l'interrupteur 260 de charge. L'état logique '0' ou '1' du signal de commande V_{MS} signal en sortie dépend ici de celui d'un signal T_{ON} appelé signal indicateur configuration et d'un signal V_{OV} de détection de surtension appliqués en entrée de l'étage 326. Dans l'exemple de réalisation particulier illustré, le signal de commande V_{MS} est produit en sortie d'une porte 338 OU de l'étage 326 du bloc de contrôle 320 logique. Ainsi, la fermeture (autrement dit la mise dans un état passant) de l'interrupteur de charge 260 est réalisée lorsque le signal de commande V_{MS} se trouve dans un état logique donné, ici un état logique '1', le placement du signal de commande signal V_{MS} dans cet état donné se produisant lorsque au moins des signaux T_{ON} ou V_{OV} est à un niveau logique '1'.

L'interrupteur 240 de décharge, apte à alternativement connecter ou déconnecter la sortie du redresseur 210 du moyen 130 de stockage de charges est quant à lui typiquement doté ou formé d'un transistor 241 que l'on rend alternativement passant ou bloqué en fonction du niveau d'un deuxième signal de commande V_{SR} appliqué sur sa grille. Le transistor 241 peut être par exemple un transistor à enrichissement de type P, avec un caisson (BULK) qui est mis à un potentiel V_{BULK}. Ce potentiel V_{BULK} peut être modulé par le biais d'un étage 220 sélecteur de tension de caisson en fonction notamment d'un niveau de signal V_{NVC} produit par le redresseur 210 et de celui de la tension V_{OUT} aux bornes de la capacité Cₜₐₙₖ.

Le deuxième signal de commande V_{SR} dont le niveau, correspondant à un état logique '1' ou '0', détermine celui, respectivement ouvert (bloqué) ou fermé (passant), de l'interrupteur 240 de charge. Le deuxième signal de commande V_{SR} est en particulier produit par un étage 324 du bloc de contrôle 320 logique. Le deuxième signal de commande V_{SR} est dans l'exemple de réalisation illustré pris en sortie d'un inverseur 342, lui-même agencé en sortie d'une porte 340 logique ET. L'état logique '0' ou '1' du signal de commande V_{SR} dépend dans cet exemple de réalisation particulier de celui d'un signal de détection de seuil V_{POR}, d'un autre signal de détection V_{UP}, et d'un signal T_{OFF} indicateur de première configuration, appliqués en entrée de la porte 340 ET ainsi que d'un signal V_{OV} de détection de surtension appliqué en entrée de cette porte 340 une fois avoir été inversé, par exemple par le biais d'un inverseur 339. Dans l'exemple de réalisation illustré, la fermeture (autrement dit la mise dans un état passant) de l'interrupteur de décharge 240 est réalisée lorsque le deuxième signal de commande V_{SR} se trouve dans un état logique donné, dans cet exemple '0', la mise dans cet état donné étant elle-même conditionnée par chacun des signaux V_{POR}, V_{UP}, T_{OFF}, et V_{OV}, en entrée de l'étage 324. La fermeture de l'interrupteur de décharge 240 ne se produit que lorsque les signaux V_{POR}, V_{UP}, T_{OFF}, sont à un même niveau logique, ici '1', tandis que le signal V_{OV} est à un niveau logique opposé (i.e. complémentaire), ici '0'.

Le bloc de contrôle 320 logique du circuit électronique d'interface 120 permet ainsi de produire les signaux de commande V_{SR} et V_{MS} de l'ouverture et la fermeture de l'interrupteur 260 de charge, ainsi que l'ouverture et la fermeture de l'interrupteur 240 de décharge, et pour alternativement faire passer ces interrupteurs 240, 260 d'une première configuration à une deuxième configuration et inversement.

La première configuration des interrupteurs 260, 240, est celle pour laquelle l'interrupteur de charge 260 est bloqué (ouvert) de sorte que la borne P1 et la borne M1 sont déconnectées et l'interrupteur 240 de charge est passant (fermé), de sorte que le redresseur 210 est connecté au moyen 130 de stockage de charges. Une telle configuration peut être réalisée par le biais des signaux de commande V_{MS} et V_{SR} dans cet exemple tous les deux mis à un niveau logique '0'.

La deuxième configuration des interrupteurs 260, 240 est celle pour laquelle l'interrupteur de charge 260 est passant (fermé) de sorte que la borne P1 et la borne M1 sont connectées et l'interrupteur 240 de décharge est bloqué (ouvert), de sorte que le redresseur 210 est déconnecté du moyen 130 de stockage de charges. Une telle configuration peut être réalisée par le biais des signaux de commande V_{MS} et V_{SR} par exemple tous les deux mis à un niveau logique '1'.

Au démarrage, lorsque l'on vient d'actionner l'interrupteur sans-fil, la tension de sortie V_{OUT} aux bornes de la capacité Cₜₐₙₖ est proche de 0V et le bloc de contrôle 320 place par défaut les interrupteurs 240, 260 dans la première configuration. Dans l'exemple illustré, le signal Vpor mis à '0' rend les entrées R et S respectivement à '1' et '0'. Le signal T_{ON} est par conséquent à '0'. Les signaux de commande V_{MS} et V_{SR} sont dans des états respectifs, par exemple '1' et '0' rendant l'interrupteur de décharge 260 fermé et l'interrupteur de charge 240 ouvert.

Le dispositif se trouve alors dans le mode de fonctionnement que l'on qualifie de « linéaire ». Le dispositif permet de récupérer de manière passive de l'énergie jusqu'à atteindre une tension minimale, V_{min_seuil}, par exemple de l'ordre de 1.5V, seuil à partir duquel le dispositif est susceptible de pouvoir changer de mode de fonctionnement et peut passer dans un mode de fonctionnement appelé « Boost ».

Pour détecter ce seuil, le circuit d'interface 120 est ici doté en outre d'un bloc 270 de détection de valeur minimale de la tension de sortie V_{OUT}, apte à détecter un passage de cette tension V_{OUT} appliquée au moyen de stockage 130 de charges électriques au-dessus de la valeur seuil minimale et produire lorsque cette détection est réalisée, un signal de détection de seuil au bloc 320 de contrôle du circuit de commande. Dans cet exemple, le signal de détection produit se traduit par un changement d'état logique du signal V_{POR}, par exemple mis à un niveau logique '1'.

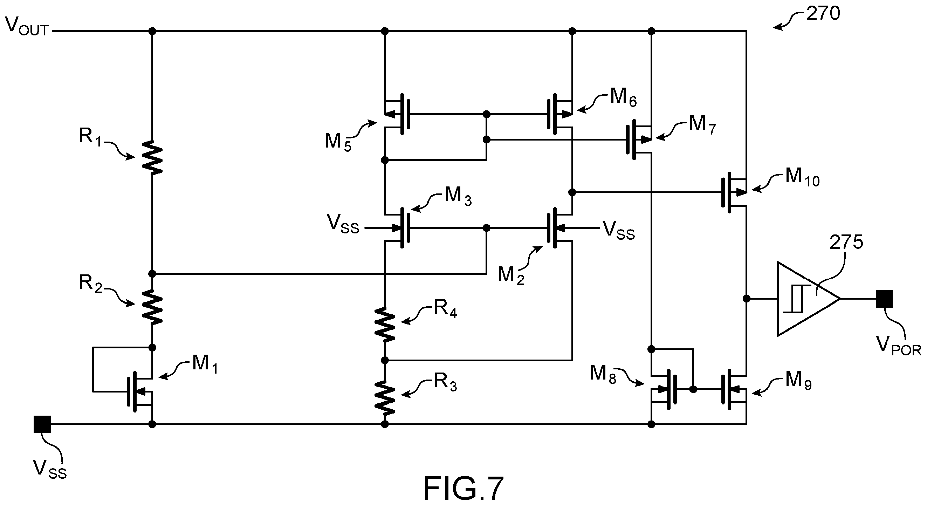

Un exemple particulier de réalisation du bloc 270 de détection est donné sur la figure 7. Il comporte ici une bascule à seuil qui peut être de type bascule de Schmitt non-inverseuse 275 délivrant en sortie le signal logique V_{POR} et dont l'entrée analogique est reliée à un étage recevant la tension V_{OUT} et doté d'une pluralité de transistors M₁, M₂, M₃, M₅, M₆, M₇, M₈, M₉, M₁₀. La valeur seuil minimale au-dessus de laquelle le bloc 320 de contrôle émet le signal de détection, dépend notamment du choix des valeurs de résistances R₁, R₂, R₃, R₄ et de taille de transistors M₁, M₂, M₃ du circuit.

Le bloc 320 de contrôle logique est ici configuré de sorte qu'un changement de mode du mode linéaire au mode « Boost » est conditionné par l'état du signal de commande V_{SR} lui-même conditionné par l'état du signal Vₚₒᵣ.

Dans l'exemple de réalisation particulier illustré, l'étage 324 produisant le signal de commande V_{SR} ne peut être mis à un état logique permettant d'ouvrir l'interrupteur de décharge 240 que si le signal de détection de seuil est produit, ce qui correspond à un changement d'état logique du signal Vₚₒᵣ, dans cet exemple mis à '1'. Ce signal Vₚₒᵣ est également transmis à un étage 322 apte à produire des signaux indicateurs T_{OFF}, T_{ON}, complémentaires servant de signaux d'entrée des étages 324, 326 du bloc de contrôle.

Un passage du mode de fonctionnement linéaire au mode de fonctionnement Boost est effectivement réalisé lorsqu'une tension égale au produit Rₘᵢₙ^{∗}Iₛₑₙₛₑ d'un courant de charge Iₛₑₙₛₑ à destination de la capacité Cₜₐₙₖ disposée en sortie du circuit d'interface 120 par une résistance 312 de valeur prédéterminée Rₘᵢₙ devient inférieure à la tension de sortie V_{OUT} aux bornes de la capacité Cₜₐₙₖ. Le courant de charge Iₛₑₙₛₑ provient typiquement d'un détecteur de courant du circuit.

Dans ce cas de figure, où V_{OUT} ≥ Rₘᵢₙ^{∗}Iₛₑₙₛₑ il devient préférable d'adopter le mode de fonctionnement en mode « Boost » car l'impédance de charge de l'étage récupérateur 110 peut alors être maîtrisée et mise à une valeur Rₒₚₜ.

Le mode de fonctionnement « Boost » permet d'optimiser la récupération d'énergie du système sur les alternances de plus faible amplitude du signal en sortie de l'étage 110 de récupération.

Le circuit d'interface 120 peut être muni d'un bloc de détection 310 de mode de fonctionnement. Ce bloc 310 est typiquement doté d'un comparateur 311 pour comparer la tension de sortie V_{OUT} au produit Iₛₑₙₛₑ∗Rₘᵢₙ.

Avantageusement, la résistance Rₘᵢₙ est telle que : Rₘᵢₙ = K1∗Rs= K2∗Rₒₚₜ, avec K2<K1. Les coefficients K1 et K2 dépendent du type d'étage de récupération d'énergie électromagnétique utilisé. Par exemple, on peut prévoir Rₘᵢₙ = 4^{∗}Rₛ = 2^{∗} Rₒₚₜ dans le cas d'un récupérateur particulier utilisé dans un système d'interrupteur sans fil particulier.

Le comparateur 311 produit en sortie un signal V_{BOOST} qui, lorsque la tension de sortie V_{OUT} devient supérieure à Iₛₑₙₛₑ∗Rₘᵢₙ, change d'état et passe par exemple à un niveau logique '1', ce qui peut permettre de déclencher un passage au mode de fonctionnement Boost.

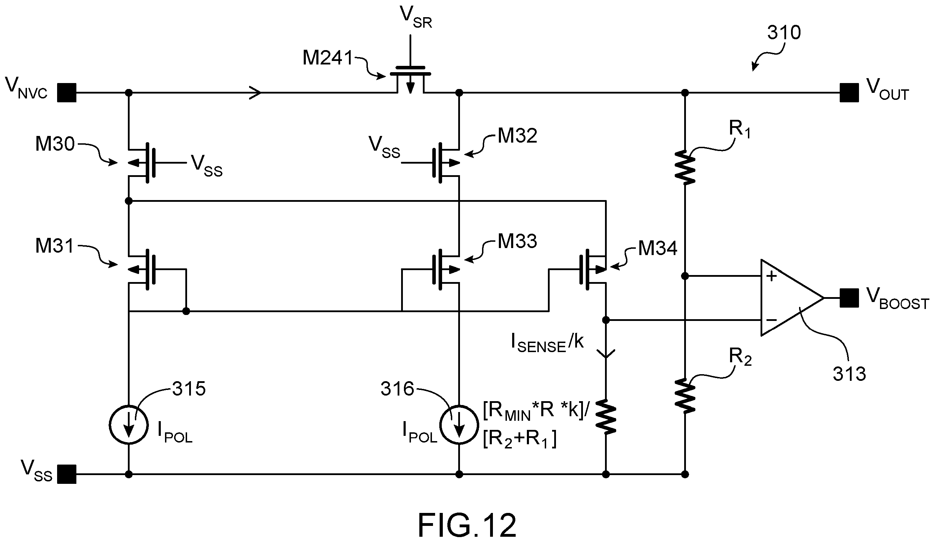

Selon un exemple de réalisation particulier illustré sur la figure 12, le bloc de détection 310 est formé de transistors M₃₀, M₃₁, M₃₂, M₃₃, M₃₄, et délivre en sortie le signal V_{BOOST} par l'intermédiaire d'un comparateur 313 de tension configuré pour, lorsque le signal de commande V_{SR} est dans un état rendant le transistor interrupteur M₂₄₁ passant comparer un potentiel proportionnel à la tension de sortie V_{OUT} et qui dépend de valeurs de résistances R₁, R₂ et un potentiel qui dépend du courant Iₛₑₙₛₑ d'une résistance R, elle-même dépendante des valeurs de résistances R₁, R₂, et d'une valeur Rₘᵢₙ qui est choisie en fonction de la résistance de sortie du récupérateur.

Le signal V_{BOOST} est pour cela transmis au bloc 320 de contrôle et en particulier à un étage 322 apte à produire les signaux indicateurs T_{OFF}, T_{ON} respectivement de première configuration et deuxième configuration. Les signaux indicateurs T_{OFF}, T_{ON}, ont ici des niveaux logiques complémentaires l'un par rapport à l'autre. Les signaux indicateurs T_{OFF}, T_{ON} sont ré-injectés en entrée de l'étage 322 du bloc de contrôle.

Des changements respectifs d'états des signaux indicateurs T_{OFF}, T_{ON} de configuration sont susceptibles de modifier celui des signaux de commande V_{MS} et V_{SR} de l'état des interrupteurs 260, 240. Par exemple, lorsque le signal indicateur T_{ON} de configuration passe à un niveau logique '1', cela est susceptible d'entrainer un changement d'état du signal de commande V_{MS} qui peut passer à un niveau logique '1', tandis que le signal indicateur T_{OFF} est à un niveau '0' (complémentaire de celui de T_{ON}) qui entraine un changement d'état du signal de commande V_{SR}.

Dans l'exemple de réalisation particulier illustré sur la figure 4, le signal V_{BOOST} de déclenchement est en particulier transmis en entrée d'une porte ET 334, dont la sortie sert d'entrée à une porte OU 336 ayant une sortie est elle-même reliée à l'entrée S (SET) d'une bascule 337 de type RS délivrant en sortie le signal T_{ON} indicateur de deuxième configuration.

Une détection d'une condition V_{OUT} ≥ Rₘᵢₙ^{∗}Iₛₑₙₛₑ permet ainsi de mettre à un niveau logique '1' le signal V_{BOOST} qui, à condition que les signaux Vpor et T_{OFFD} soient également à un niveau logique '1' permet de déclencher une mise à un niveau logique '1' de l'entrée SET d'une bascule RS 337 de l'étage 322, ce qui peut entrainer une mise à un niveau logique '1' du signal T_{ON} produit en sortie de l'étage 322, et par conséquent une mise à un niveau logique '0' du signal T_{OFF} indicateur de première configuration et résultant d'une inversion du signal T_{ON} par un inverseur 341 placé en sortie de la bascule 337. Cela peut permettre ainsi de placer les signaux de commande V_{SR} et V_{MS} dans des états respectifs permettant de mettre le dispositif dans la deuxième configuration des interrupteurs 240, 260.

Dans le mode « Boost », une fois avoir été mis dans la deuxième configuration, le circuit peut être remis dans la première configuration puis mis à nouveau dans la deuxième configuration des interrupteurs. Une alternance d'une ou plusieurs phases de deuxième configuration et de première configuration peut être ainsi réalisée. En mode « Boost », la boucle alterne ainsi au moins une phase de charge de l'inductance L du récupérateur 110 avec un interrupteur de charge 260 fermé pendant une durée D_Ton, puis au moins une phase de décharge de l'inductance L avec un interrupteur de décharge 240 fermé pendant une durée maximale D_Toffmax qui est au plus égale à la durée D_TON de charge. Typiquement, plusieurs alternances sont réalisées entre la première et deuxième configuration. On notera qu'il n'y a pas d'autres configurations intermédiaires entre ces deux configurations et que l'on alterne donc dans ce mode de réalisation uniquement entre ces deux configurations.

La durée des phases correspondant à la deuxième configuration est fixée à une durée D_TON. Pour cela, le dispositif est pourvu d'un bloc 290 indicateur d'écoulement de durée de deuxième configuration qui, après réception dudit signal indicateur T_{ON}, génère après un délai fixé D_TON, un signal indicateur T_{OND} d'écoulement de durée de deuxième configuration à destination de l'étage 322 du bloc 320 de contrôle logique. Une fois ce délai fixé écoulé, le bloc 320 de contrôle logique peut alors modifier l'état des signaux T_{ON} et T_{OFF} ce qui déclenche un changement d'état des signaux de commande V_{MS} et V_{SR} et permet de revenir dans la première configuration.

Le bloc 290 indicateur d'écoulement de durée de deuxième configuration peut être par exemple doté d'une ou plusieurs capacités dont le temps de charge détermine le délai D_TON fixé.

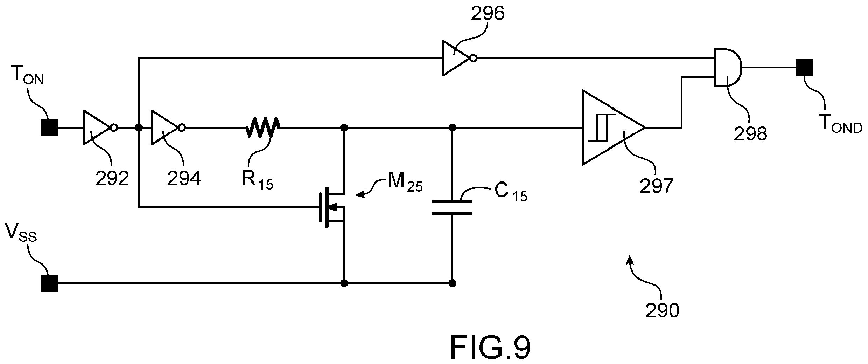

Un exemple de réalisation particulier du premier bloc 290 est donné sur la figure 9. Dans cet exemple, le signal indicateur T_{OND} d'écoulement de durée de deuxième configuration est délivré par une porte ET 298 dont une entrée reçoit le signal T_{ON} ici après avoir été inversé puis ré-inversé par le biais d'inverseurs 292, 296 et dont une autre entrée est reliée à la sortie d'une bascule à seuil 297 non inverseuse qui dépend de la charge d'une capacité C₁₅, lorsqu'elle est connectée à une résistance R₁₅ et n'est pas mise en court-circuit par un interrupteur formé ici d'un transistor M₂₅ dont la grille est commandée par l'inverse du signal T_{ON}. Dans cet exemple de réalisation, pour pouvoir régler la durée du délai D_TON, on adapte les valeurs respectives de la capacité C₁₅, et de la résistance R₁₅. Une durée maximale D_TOFFmax des phases correspondant à la première configuration est également prédéterminée. Pour cela, le dispositif est pourvu d'un bloc 300 indicateur d'écoulement de durée maximale de première configuration pour, après réception du signal indicateur T_{OFF}, générer après un délai prédéterminé D_TOFFmax un signal indicateur T_{OFFD} d'écoulement maximal de durée de première configuration.

Le bloc 300 indicateur d'écoulement maximal de durée de première configuration peut être par exemple doté d'une ou plusieurs capacités dont le temps de charge détermine le délai D_TOFFmax.

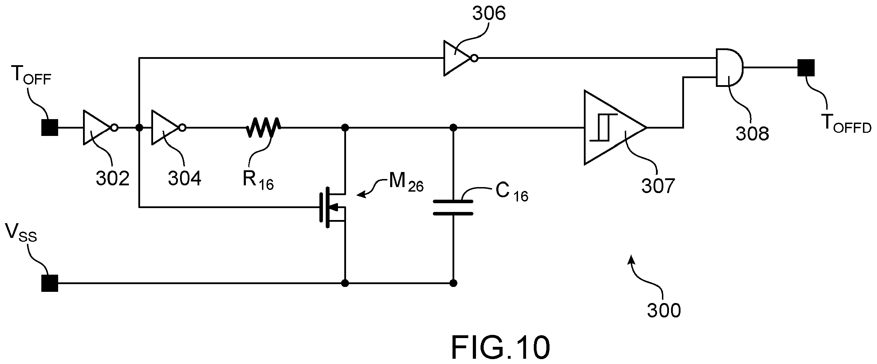

Un exemple de réalisation particulier de ce bloc 300 générant le signal T_{OFFD} est donné sur la figure 10. Dans cet exemple, le bloc 300 à une construction similaire à celui du bloc 290 générant le T_{OND}, les composants 292, 294, R₁₅, M₂₅, C₁₅, 296, 297, 298 étant remplacés par des composants 302, 304, R₁₆, M₂₆, C₁₆, 306, 307, 308 de même type.

Ainsi, dans cet exemple de réalisation, pour pouvoir régler la durée du délai D_TOFFmax, on adapte les valeurs respectives de la capacité C₁₆, et de la résistance R₁₆.

L'écoulement de la première configuration peut être déclenché consécutivement à un changement d'état du signal indicateur T_{OFFD} d'écoulement maximal ou par un signal de détection de seuil de courant V_{IMIN} de charge Iₛₑₙₛₑ produit par un étage 280 de détection de courant minimal. Cet étage peut être muni d'un comparateur de courant 281, pour comparer le courant I_{SENSE} avec un courant seuil I_{refmin}. Le signal de détection de courant minimal V_{IMIN} à destination du bloc de contrôle 320 en sortie du comparateur 321 indique, par un changement d'état, par exemple mis à un niveau logique '1' lorsque le courant I_{SENSE} passe en dessous de ce seuil.

Dans l'exemple de réalisation de la figure 4, le bloc 320 de contrôle logique est ainsi configuré pour modifier l'état du signal indicateur T_{ON} et de l'autre signal indicateur T_{OFF}, complémentaire de ce dernier, en fonction des états respectifs des entrées R et S de la bascule 337, l'entrée R étant dépendante des signaux T_{ON}, T_{OND}, l'entrée S étant dépendante des signaux T_{OFF}, T_{OFFD}.

La deuxième configuration est signifiée par exemple par une mise à un niveau '1' du signal indicateur T_{ON}, tandis que le signal complémentaire T_{OFF} est mis à '0'. lorsque la deuxième configuration est écoulée, cet écoulement est signifié par une mise à un niveau '1' du signal T_{OND}, ce qui entraine une mise à '1' de l'entrée R de la bascule 337 et permet, dans la mesure où les signaux T_{OFF} et T_{OFFD} sont à '0', un changement d'état des signaux T_{ON} et T_{OFF} entrainant une mise dans la première configuration.

La première configuration est signifiée par une mise à '1' du signal indicateur T_{OFF}, tandis que le signal complémentaire T_{ON} est mis à '0'. Lorsque la première configuration est écoulée, cet écoulement est signifié par une mise à un niveau '1' du signal T_{OFFD}, ce qui est susceptible d'entrainer une mise à '0' de l'entrée S de la bascule 337 et peut permettre, dans la mesure où les signaux T_{ON} et T_{OND} sont à '1', un changement d'état des signaux T_{ON} et T_{OFF}.

La durée fixée D_TON peut être telle que L/2Rs ≤ D_TON ≤ L/Rs. Pour un récupérateur d'énergie particulier d'un système interrupteur sans fil particulier, on peut prévoir par exemple la durée maximale prédéterminée D_TOFFmax telle que D_TON= (4^{∗}L)/(7^{∗}Rs)D_TOFFmax.

De telles durées permettent d'avoir une impédance de charge vue par le récupérateur au plus proche d'une impédance optimale Rₒₚₜ.

Par exemple, dans le cas particulier d'un récupérateur avec une inductance ayant de spires de diamètre de l'ordre de 100 µm et un coefficient de foisonnement de l'ordre de 0.7, les durées D_TON et D_TOFFmax peuvent être égales et de l'ordre de 80 µs.

Le circuit 120 d'interface peut être également doté d'un autre étage 315 de détection muni d'un comparateur 316, apte à comparer la tension de sortie V_{OUT} appliquée au moyen de stockage 130 de charges électriques et la tension V_{NVC} en sortie du redresseur, et produire un signal V_{UP} de comparaison indiquant, par exemple lorsque V_{UP} est à un état logique '1' lorsque la tension V_{NVC} en sortie du redresseur 210 dépasse la tension de sortie V_{OUT}. Dans cet exemple le maintien fermé de l'interrupteur de décharge 260 est ainsi également conditionné par celui d'un état logique '1' du signal Vᵤₚ de comparaison. Lorsque cette tension V_{NVC} devient inférieure à V_{OUT}, un changement d'état du signal V_{UP} de comparaison qui passe à '0' provoque celui du signal de commande V_{SR} de l'interrupteur de décharge 260 de sorte à l'ouvrir.

Pour empêcher une surtension en sortie V_{OUT} du circuit 120 d'interface, celui-ci peut être avantageusement doté d'un étage 230 de détection de surtensions, apte à produire un signal de détection de surtension lorsque la tension V_{OUT} de sortie dépasse un seuil prédéterminé. Cet étage 230 de détection de surtensions est dans cet exemple doté d'un comparateur 231 de tension configuré pour comparer la tension de sortie V_{OUT} avec une tension de seuil prédéterminée V_{OVTH}, par exemple de 5.3V.

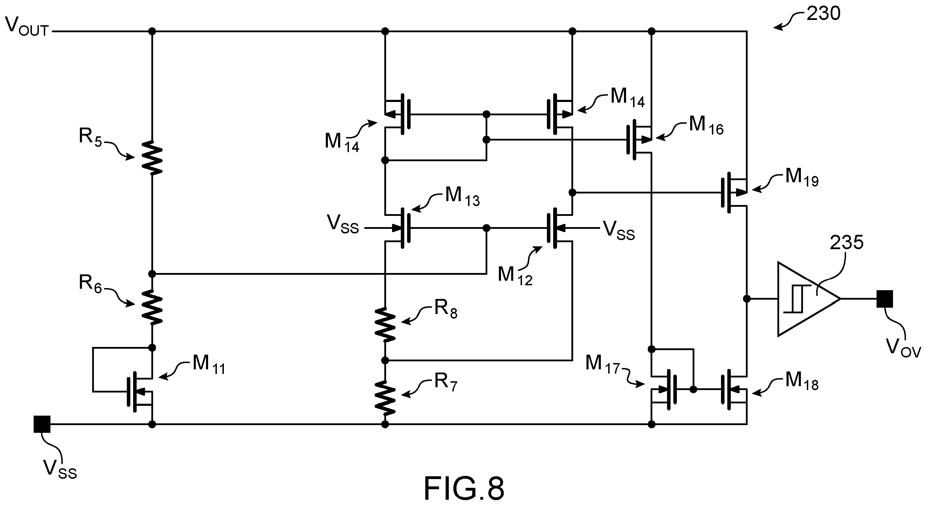

Un exemple particulier de réalisation de l'étage 230 de détection de surtensions est donné sur la figure 8. Il reprend dans cet exemple une construction similaire à celle de l'étage 270 de détection de valeur de tension de sortie minimale.

L'étage 230 comporte ici une bascule à seuil de type bascule de Schmitt non-inverseuse 235 délivrant en sortie un signal logique Vov et dont l'entrée analogique est reliée à un étage recevant la tension V_{OUT} et doté d'une pluralité de transistors M₁₁, M₁₃, M₁₄, M₁₅, M₁₆, M₁₇, M₁₈, M₁₉.

Le signal de détection de surtension se traduit par un changement d'état logique du signal Vov émis en entrée des étages 324, 326 du bloc 320 de contrôle 320. Dans l'exemple particulier illustré sur la figure 4, un changement d'état, par exemple à un niveau '1' du signal Vov modifie l'état du signal de commande V_{SR} de l'interrupteur de décharge 240 et est également susceptible de modifier l'état du signal de commande V_{MS} de l'interrupteur de charge 260. Ainsi, lorsque le seuil V_{OVTH} est dépassé, le bloc de contrôle 320 est configuré pour, consécutivement à la réception dudit signal de détection de surtension Vov, mettre le premier signal de commande V_{MS} à un niveau permettant de rendre passant l'interrupteur 260 de charge et de mettre le deuxième signal de commande V_{SR} à un niveau permettant de rendre bloqué l'interrupteur de décharge 240.

Avantageusement, consécutivement à la détection d'un seuil de tension en sortie, on place le potentiel de caisson (bulk) du transistor 241 de décharge à une tension qui résulte d'une sélection du maximum entre la tension de sortie VOUT et le potentiel V_{NVC} délivré par le redresseur 210 et appliqué à la source du transistor de décharge 241.

Cette sélection peut être mise en œuvre au moyen d'un étage 220 de sélection de potentiel de caisson doté d'un sélecteur 221 de maximum doté d'une entrée recevant la tension de sortie V_{OUT} du dispositif d'interface et une autre entrée recevant le potentiel V_{NVC} de sortie V_{OUT} du dispositif d'interface et émettant en sortie un potentiel V_{MAX} égal au maximum de ces deux tensions.

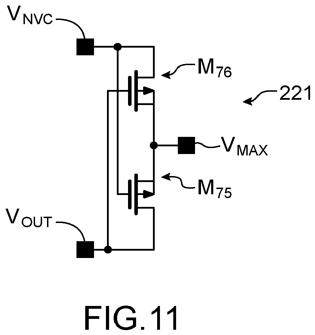

Un exemple de réalisation particulier du sélecteur 221 de maximum est donné sur la figure 11 sous forme d'un circuit à transistors M₇₅, M₇₆ à source commune délivrant le potentiel V_{MAX}. Les grilles respectives de ces transistors M₇₅, M₇₆ reçoivent respectivement la tension de sortie V_{OUT} et le potentiel V_{NVC} et les drains respectifs reçoivent respectivement le potentiel V_{NVC} et la tension de sortie V_{OUT}.

Ce sélecteur 221 est typiquement associé à un multiplexeur 222 configuré pour propager, en fonction de la valeur du signal de détection de surtension Vov émis en sortie de l'étage 230 de détection de surtensions, une de ses entrées en sortie, entre une première entrée mise au potentiel de sortie V_{OUT} et une deuxième entrée mise au potentiel V_{MAX} émis par l'étage 221. La sortie du multiplexeur 222 est connectée au caisson (bulk) du transistor de décharge 241 et lui applique par défaut la tension de sortie VOUT. Puis, lorsqu'un dépassement de seuil par le circuit de détection 230 est détecté, le maximum de tension entre la tension de sortie VOUT et le potentiel V_{NVC} délivré par le redresseur 210.

Le tableau ci-dessous établit une comparaison de performances en termes d'énergie récupérée et d'efficacité, entre d'une part un système de récupération d'énergie conventionnel tel qu'illustré sur la figure 1 et un système de récupération doté d'un circuit d'interface 120 tel que décrit précédemment, et ce pour différents étages de récupération correspondant notamment à différents tailles de bobinages (DiamCu) et différents facteurs de qualités kf. Les résultats sont donnés avec une tension de sortie fixée à V_{OUT}=2.5V.

| **Diam Cu** | **kf** | **Eopt (µJ)** | **Erecup** **Figure 1** | **Efficacité (%)** | **Erecup Circuit 120 (µJ)** | **Efficacité Circuit 120 (%)** |
|---|---|---|---|---|---|---|
| 63µm Rs=220Ω L=18mH | 0,415 | 785 | 423 | 54,4 | 530 D_Tοn=46µs | 68,2 |
| 80 µm Rs=140Ω L=19,6mH | 0,7 | 955 | 487 | 51 | 597 D_Ton=80µs | 62,5 |
| 100 µm Rs=60Ω L=8mH | 0,7 | 955 | 535 | 56 | 766 D_Ton=80µs | 80,2 |
| 110 µm Rs=40Ω L=5,5mH | 0,7 | 955 | 510 | 53,4 | 824 Ton=80µs | 86,2 |

Le circuit 120 d'interface sans inductance permet d'obtenir de meilleurs rendements et d'extraire plus d'énergie du récupérateur qu'une solution conventionnelle avec composants discrets. Cela est d'autant plus vrai que l'impédance de sortie du récupérateur est faible et que le diamètre Dcu des spires de cuivre formant la bobine est important.

Les avantages apportés par le circuit d'interface 120 bi-modes décrit précédemment sont les suivants :
- un rendement électrique amélioré avec une énergie récupérée proche de l'énergie optimale pour des récupérateurs à faible impédance de sortie ;
- une adaptabilité au récupérateur utilisée en adaptant les paramètres de certains blocs du circuit en fonction de l'impédance de sortie Rs du récupérateur 110 ;
- une optimisation du récupérateur qui permet d'utiliser un récupérateur avec un diamètre de cuivre de la bobine important ce qui permet de diminuer son impédance de sortie et donc le cout du récupérateur ;
- un faible cout d'intégration et d'ensemble des composants nécessaires ;
- la mise en œuvre d'une architecture utilisant l'inductance du récupérateur où l'on limite l'excursion en tension sans devoir nécessairement utiliser des composants spécifiques.

Par ailleurs, on obtient des niveaux de performances sensiblement les mêmes par rapport à une solution qui est plus onéreuse et qui prévoit un circuit d'interface 520 de type ASIC tel que celui illustré sur la figure 6. Ce circuit d'interface de la figure 6 ne fait pas partie de la présente invention.

Ce circuit d'interface 520 fait cette fois appel à au moins une inductance Lₑₓₜ supplémentaire externe. Le circuit permet d'alterner des phases de charge de l'inductance externe Lext durant lesquelles l'interrupteur de charge 660 est fermé et l'interrupteur 640 de décharge ouvert durant un temps fixé DTon et des phases de décharge pendant une durée DToff où l'interrupteur 660 de charge est fermé (passant) et l'interrupteur de décharge 640 est fermé.

La durée DTon est par exemple telle que DT_{On}=1.85^{∗}Lext/Rs pour un récupérateur donné particulier utilisé dans un système de récupérateur sans fil particulier. Cette durée est fixée par un bloc indicateur d'écoulement 690 de durée de fonction semblable à celui 290 décrit précédemment en lien avec la figure 4.

La durée DToff prend fin lorsque le courant de l'inductance externe Lext s'annule. La durée DToff est donnée par un signal V_{IMIN} produit par un étage 680 de détection de courant minimal de fonction semblable à celui 280 décrit précédemment en lien avec la figure 4. Les interrupteurs de décharge 640 et de charge 660 sont ici commandés par un bloc de contrôle 620 logique formé d'étages 626, 624, du type de ceux 322, 324 du bloc de contrôle 320 décrit précédemment en lien avec la figure 4.

Le bloc de contrôle 620 logique est doté d'un autre étage 620 de fonction similaire à celle du bloc 320 décrit précédemment en lien avec la figure 4, pour produire des signaux indicateurs de configuration T_{ON}, T_{OFF}, mais dont les états respectifs dépendent cette fois des signaux T_{ON}, T_{OND}, T_{OFF}, V_{IMIN} et d'un signal Vₚₒᵣ produit par un étage 670 de détection de valeur de tension de sortie minimale du type de celui 270 décrit précédemment en lien avec la figure 4. Le circuit 520 est, comme pour la solution sans inductance externe, également doté d'un étage 630 de détection de surtension et d'un circuit 620 de sélection de potentiel de caisson. Le circuit 520 est ici doté en outre d'un étage 605 de démarrage à froid recevant un signal Vshu délivré par un étage 628 du bloc 620 de contrôle et le signal Vpor, et configuré pour placer des bornes NVC et NVC2 de sortie du redresseur 210 selon une configuration donnée au démarrage lorsque la tension de sortie Vout est inférieure à un seuil donné, puis modifier cette configuration lorsque ce seuil est atteint. Ce circuit d'interface 520 permet d'extraire davantage d'énergie du récupérateur qu'une solution selon l'art antérieur mise en œuvre avec des composants discrets, mais s'avère plus encombrante lorsqu'intégrée sur silicium et également plus onéreuse que le circuit décrit précédemment en lien avec la figure 4.

## Revendications

1. Circuit électronique d'interface (120) pour récupérateur d'énergie électromagnétique, le circuit électronique d'interface étant apte à être disposé entre un étage (110) récupérateur d'énergie électromagnétique et un étage (130-140) de charge, l'étage récupérateur d'énergie électromagnétique présentant un circuit électrique équivalent formé en série d'un générateur de tension alternative (101), d'une inductance (L) et d'une impédance de sortie (Rs), le générateur produisant un signal alternatif AC résultant d'une conversion d'énergie mécanique en énergie électromagnétique, l'étage de charge (130-140) étant doté d'un moyen (130) de stockage de charges électriques, en particulier une capacité (Cₜₐₙₖ), ledit circuit électronique d'interface comprenant :
- un convertisseur AC/DC configuré pour convertir un signal d'entrée entre une première borne (P1) et une deuxième borne (M1) connectées en sortie dudit étage de récupération (110), et produire un signal DC en entrée de l'étage de charge, le convertisseur étant doté d'un redresseur pour produire un signal redressé (VNVC) à destination dudit moyen de stockage (130) de charges électriques,
- un premier interrupteur (260), agencé entre la première borne (P1) et la deuxième borne (M1) et apte à alternativement connecter ou déconnecter la première borne (P1) et la deuxième borne (M1) l'une de l'autre, l'état fermé ou ouvert du premier interrupteur (260) étant régi par un premier signal de commande (VMS),
- un deuxième interrupteur (240), disposé entre une sortie du redresseur (210) et l'étage (130-140) de charge et apte à alternativement connecter ou déconnecter la sortie du redresseur dudit étage de charge, l'état ouvert ou fermé du deuxième interrupteur (240) étant régi par un deuxième signal de commande (VSR),
le circuit électronique d'interface étant doté d'un bloc de contrôle (320) logique configuré pour produire ledit premier signal de commande (VMS) et ledit deuxième signal de commande (VSR), le bloc de contrôle (320) étant apte à faire alternativement passer lesdits interrupteurs d'une première configuration à une deuxième configuration et de la deuxième à la première configuration,
la première configuration étant une configuration dans laquelle le premier interrupteur (260) est ouvert et le deuxième interrupteur (240) est fermé, de sorte que ladite première borne (P1) et ladite deuxième borne (M1) sont déconnectées et la sortie dudit redresseur (210) est connectée audit moyen de stockage de charges électriques,
la deuxième configuration étant une configuration dans laquelle le premier interrupteur (260) est fermé et le deuxième interrupteur (240) est ouvert de manière à déconnecter la sortie du redresseur dudit étage de charge (130-140) et connecter entre elles la première borne (P1) et la deuxième borne (M1) de sorte à les mettre en court-circuit,
le bloc de contrôle (320) logique étant configuré en outre pour dans un mode appelé « linéaire » dudit circuit mettre lesdits interrupteurs dans la première configuration,
**caractérisé en ce que**
le bloc de contrôle (320) logique étant configuré en outre pour dans un mode de fonctionnement donné dit « de boost » distinct dudit mode linéaire : déclencher plusieurs fois une alternance entre ladite première configuration et ladite deuxième configuration,
ledit bloc de contrôle (320) logique étant configuré pour déclencher le passage du mode linéaire vers ledit mode de fonctionnement donné consécutivement à un passage d'une tension de sortie (V_{OUT}) aux bornes du moyen de stockage (130) de charges électriques au-dessus d'une valeur seuil.

2. Circuit selon la revendication 1, comprenant en outre un étage de détection (310) de mode de fonctionnement doté d'un comparateur (311) pour comparer une tension de sortie (V_{OUT}) appliquée audit moyen de stockage (Cₜₐₙₖ) de charges à une tension égale à un produit Rₘᵢₙ∗Iₛₑₙₛₑ d'un courant (Iₛₑₙₛₑ) délivré en sortie dudit redresseur (210) et apte à être injecté dans ledit moyen (130) de stockage de charges par une résistance Rₘᵢₙ de valeur prédéterminée et qui dépend d'une valeur d'impédance de sortie Rs dudit étage (110) de récupération d'énergie électromagnétique, en particulier de sorte que Rₘᵢₙ = K∗Rs, K étant un nombre réel, et générer lorsque ce produit est inférieur à la tension de sortie (V_{OUT}), un signal de déclenchement (V_{boost}) à destination dudit bloc de contrôle (320) logique et apte à déclencher un passage de la première configuration à ladite deuxième configuration et dans ledit mode de fonctionnement donné dans lequel le circuit est ensuite apte à alterner une ou plusieurs phases dans ladite première configuration et une ou plusieurs phases dans ladite deuxième configuration.

3. Circuit selon l'une des revendications 1 ou 2, dans lequel le deuxième signal de commande (V_{SR}) a un état logique qui dépend de celui d'un signal indicateur (T_{OFF}) de première configuration produit par ledit bloc (320) de contrôle logique, le premier signal de commande (V_{Ms}) a un état logique dépendant de celui d'un signal indicateur (T_{ON}) de deuxième configuration produit par ledit bloc (320) de contrôle logique et complémentaire du signal indicateur (T_{OFF}) de première configuration, le bloc de contrôle étant apte à modifier (320) ledit signal indicateur (T_{ON}) de deuxième configuration consécutivement à une réception dudit signal de déclenchement (V_{boost}), la ou les phases dans ladite deuxième configuration ayant une durée fixée D_TON à l'issue de laquelle ledit bloc de contrôle (320) modifie automatiquement le signal indicateur (T_{ON}) de deuxième configuration, la ou les phases dans ladite première configuration ayant une durée maximale prédéterminée D_TOFFmax contrôlée par le bloc de contrôle et prévues au plus égales à la durée fixée D_TON.

4. Circuit selon la revendication 3, dans lequel la durée fixée D_TON et la durée maximale prédéterminée D_TOFFmax sont telles que : L/2Rs ≤ D_TON ≤ L/Rs.

5. Circuit selon l'une des revendications 3 ou 4, doté en outre d'un premier bloc (290) indicateur d'écoulement de durée D_TON de deuxième configuration pour, après un changement d'état dudit deuxième signal indicateur (T_{ON}), générer après un délai prédéterminé égal à ladite durée fixée D_TON, un signal indicateur d'écoulement (T_{OND}) de durée de deuxième configuration à destination du bloc (320) de contrôle de sorte à déclencher un changement d'état dudit signal indicateur (T_{ON}) de deuxième configuration.

6. Circuit selon l'une des revendications 3 à 5, doté en outre : d'un bloc (300) indicateur d'écoulement de durée maximale D_TOFF de première configuration pour, après un changement d'état dudit signal indicateur (T_{OFF}) de première configuration, générer après un délai prédéterminé un signal (T_{OFFD}) d'écoulement de durée maximale de première configuration à destination du bloc (320) de contrôle apte à déclencher un changement d'état du signal indicateur (T_{OFF}) de première configuration.

7. Circuit selon l'une des revendications 1 à 6, comprenant en outre : un étage (280) de détection de courant minimal, en particulier muni d'un comparateur de courant (281), pour détecter un courant (I_{SENSE}) apte être délivré en entrée dudit étage de charge et à être injecté dans ledit moyen (Cₜₐₙₖ) de stockage de charges et lorsque ledit courant délivré en entrée dudit étage de charge passe en dessous d'un seuil (I_{refmin}), générer en conséquence un signal de détection de courant minimal (V_{IMIN}) à destination du bloc de contrôle (320) apte à déclencher un changement de configuration de la première configuration vers la deuxième configuration.

8. Circuit selon l'une des revendications 1 à 7, doté en outre d'un étage (270) de détection de valeur de tension de sortie minimale, en particulier muni d'un détecteur (271) de seuil, configuré pour détecter un passage de la tension de sortie (V_{OUT}) appliquée au moyen de stockage (130) de charges électriques au-dessus d'une valeur seuil et modifier lorsque cette détection est réalisée, un état logique d'un premier état vers un deuxième état d'un signal de détection de seuil (Vₚₒᵣ) à destination du bloc (320) de contrôle (320) logique, ledit bloc de contrôle (320) logique étant configuré pour conditionner le déclenchement d'un passage de la première configuration à la deuxième configuration à ladite modification d'état dudit signal de détection de seuil (Vₚₒᵣ).

9. Circuit selon la revendication 8, ledit bloc de contrôle (320) logique étant configuré pour déclencher le passage de la deuxième configuration à la première configuration consécutivement à un changement d'état du deuxième état vers le premier état dudit signal de détection de seuil (Vₚₒᵣ).

10. Circuit selon l'une des revendications 1 à 9, doté en outre d'un autre étage (315) de détection muni d'un comparateur (316), configuré pour comparer la tension de sortie (V_{OUT}) appliquée au moyen de stockage (130) de charges électriques et la tension (V_{NVC}) en sortie du redresseur, et produire un signal (V_{UP}=1) de comparaison ayant un état indiquant si la tension (V_{NVC}) en sortie du redresseur est supérieure à la tension de sortie (V_{OUT}) appliquée au moyen de stockage (130), le bloc de contrôle (320) étant configuré pour conditionner la fermeture du premier interrupteur (260) à une mise dans un état donné dudit signal (Vᵤₚ) de comparaison.

11. Circuit selon l'une des revendications 1 à 10, comprenant en outre un étage (230) de détection de surtensions de ladite tension (V_{OUT}) aux bornes dudit moyen (Cₜₐₙₖ) de stockage de charges, l'étage (230) détection de surtension étant doté d'un comparateur (231) configuré pour comparer ladite tension (V_{OUT}) aux bornes dudit moyen de stockage de charges avec une tension de seuil prédéterminée (V_{OVTH}), et produire un signal de détection de surtension (Vov) lorsque la tension de seuil prédéterminée est dépassée, le bloc de contrôle (320) étant en outre configuré pour, consécutivement à la réception dudit signal de détection de surtension (Vov), déclencher un changement d'état dudit deuxième signal de commande (V_{SR}) de sorte à ouvrir le deuxième interrupteur (240), la réception dudit signal de détection de surtension (Vov) étant en outre apte à déclencher un changement d'état dudit premier signal de commande (V_{MS}) de sorte à fermer le premier interrupteur (260).

12. Circuit selon la revendication 11, dans lequel le deuxième interrupteur (240) comprend un transistor (241) de décharge comportant une région de caisson, le dispositif comprenant en outre un circuit (220) de sélection de potentiel de caisson configuré pour consécutivement à la réception dudit signal de détection de surtension (Vov), sélectionner un potentiel donné, le plus élevé entre une tension (V_{NVC}) en sortie du redresseur appliqué à une borne dudit transistor (241) de décharge et ladite tension (V_{OUT}) aux bornes dudit moyen de stockage de charges, et appliquer le potentiel donné sélectionné à ladite région de caisson.

13. Circuit selon l'une des revendications 1 à 12, dans lequel le moyen (130) de stockage de charges électriques est apte à être associé à un émetteur RF (140) prévu pour émettre un signal RF en fonction du remplissage dudit moyen de stockage de charges électriques.

14. Circuit selon l'une des revendications 1 à 13, dans lequel le premier interrupteur est formé d'un transistor (261) comportant une électrode directement connectée à ladite première borne (P1) et une électrode directement connectée à la deuxième borne (M1).

15. Système d'interrupteur sans fil, comprenant :
- un étage récupérateur d'énergie électromagnétique,
- un circuit électronique d'interface selon l'une des revendications précédentes agencé en sortie de l'étage récupérateur d'énergie électromagnétique,
- un étage de charge en sortie dudit circuit électronique d'interface, l'étage de charge étant doté d'un moyen (130) de stockage de charges électriques et d'un émetteur RF (140) prévu pour émettre un signal RF en fonction du remplissage dudit moyen (Cₜₐₙₖ) de stockage de charges électriques.

## Patentansprüche

1. Elektronische Schnittstellenschaltung (120) zur Wiedergewinnung von elektromagnetischer Energie, wobei die elektronische Schnittstellenschaltung dazu ausgelegt ist, zwischen einer Stufe (110) zur Wiedergewinnung von elektromagnetischer Energie und einer Ladestufe (130-140) angeordnet zu sein, wobei die Stufe zur Wiedergewinnung von elektromagnetischer Energie eine äquivalente elektrische Schaltung aufweist, die durch einen Wechselspannungsgenerator (101), eine Induktanz (L) und eine Ausgangsimpedanz (Rs) in Reihe gebildet ist, wobei der Generator ein AC-Wechselsignal erzeugt, das aus einer Umwandlung von mechanischer Energie in elektromagnetische Energie resultiert, wobei die Ladestufe (130-140) mit einem Mittel (130) zum Speichern von elektrischen Ladungen ausgestattet ist, insbesondere einer Kapazität (Cₜₐₙₖ), wobei die elektronische Schnittstellenschaltung umfasst:
- einen AC-DC-Wandler, der dazu konfiguriert ist, ein Eingangssignal zwischen einem ersten Anschluss (P1) und einem zweiten Anschluss (M1), die am Ausgang der Wiedergewinnungsstufe (110) angeschlossen sind, umzuwandeln und ein DC-Signal am Eingang der Ladestufe zu erzeugen, wobei der Wandler mit einem Gleichrichter ausgestattet ist zum Erzeugen eines gleichgerichteten Signals (VNVC) mit Bestimmung für das Speichermittel (130) für elektrische Ladungen,
- einen ersten Unterbrecher (260), der zwischen dem ersten Anschluss (P1) und dem zweiten Anschluss (M1) angeordnet und dazu ausgelegt ist, alternativ den ersten Anschluss (P1) und den zweiten Anschluss (M1) miteinander zu verbinden oder voneinander zu trennen, wobei der offene oder geschlossene Zustand des ersten Unterbrechers (260) durch ein erstes Steuersignal (VMS) geregelt wird,
- einen zweiten Unterbrecher (240), der zwischen einem Ausgang des Gleichrichters (210) und der Ladestufe (130-140) angeordnet und dazu ausgelegt ist, alternativ den Ausgang des Gleichrichters mit der Ladestufe zu verbinden oder davon zu trennen, wobei der offene oder geschlossene Zustand des zweiten Unterbrechers (240) durch ein zweites Steuersignal (VSR) geregelt wird,
wobei die elektronische Schnittstellenschaltung mit einem Logiksteuerblock (320) ausgestattet ist, der dazu konfiguriert ist, das erste Steuersignal (VMS) und das zweite Steuersignal (VSR) zu erzeugen, wobei der Steuerblock (320) dazu ausgelegt ist, die Unterbrecher alternativ von einer ersten Konfiguration zu einer zweiten Konfiguration und von der zweiten zur ersten Konfiguration übergehen zu lassen,
wobei die erste Konfiguration eine Konfiguration ist, in der der erste Unterbrecher (260) geöffnet ist und der zweite Unterbrecher (240) geschlossen ist, derart, dass der erste Anschluss (P1) und der zweite Anschluss (M1) getrennt sind, und der Ausgang des Gleichrichters (210) mit dem Speichermittel für elektrische Ladungen verbunden ist,
wobei die zweite Konfiguration eine Konfiguration ist, in der der erste Unterbrecher (260) geschlossen ist und der zweite Unterbrecher (240) geöffnet ist, derart, dass der Ausgang des Gleichrichters von der Ladestufe (130-140) getrennt ist und der erste Anschluss (P1) und der zweite Anschluss (M1) miteinander verbunden sind, derart, dass sie kurzgeschlossen sind,
wobei der Logiksteuerblock (320) ferner dazu konfiguriert ist, in einem als "linear" bezeichneten Modus der Schaltung die Unterbrecher in die erste Konfiguration zu versetzen,
**dadurch gekennzeichnet, dass**
der Logiksteuerblock (320) ferner dazu konfiguriert ist, in einem als "Boost" bezeichneten Funktionsmodus, der von dem linearen Modus verschieden ist: mehrere Male eine Alternierung zwischen der ersten Konfiguration und der zweiten Konfiguration auszulösen,
wobei der Logiksteuerblock (320) dazu konfiguriert ist, den Übergang vom linearen Modus zum gegebenen Funktionsmodus im Anschluss an einen Übergang einer Ausgangsspannung (V_{OUT}) an den Anschlüssen des Speichermittels (130) für elektrische Ladungen über einen Schwellenwert hinaus auszulösen.

2. Schaltung nach Anspruch 1, ferner umfassend eine Detektionsstufe (310) für den Funktionsmodus, die ausgestattet ist mit einem Komparator (311) zum Vergleichen einer Ausgangsspannung (V_{OUT}), die an das Speichermittel (Cₜₐₙₖ) für Ladungen angelegt ist, mit einer Spannung gleich einem Produkt Rₘᵢₙ x Iₛₑₙₛₑ eines Stroms (Iₛₑₙₛₑ), der am Ausgang des Gleichrichters (210) geliefert wird und dazu ausgelegt ist, in das Speichermittel (130) für Ladungen durch einen Widerstand Rₘᵢₙ mit vorbestimmtem Wert injiziert zu werden, und der von einem Ausgangsimpedanzwert Rs der Stufe (110) zur Wiedergewinnung von elektromagnetischer Energie abhängt, insbesondere derart, dass Rₘᵢₙ = K × Rs, wobei K eine reelle Zahl ist, und dann, wenn dieses Produkt kleiner als die Ausgangsspannung (V_{OUT}) ist, ein Auslösesignal (V_{boost}) mit Bestimmung für den Logiksteuerblock (320) zu generieren, das dazu ausgelegt ist, einen Übergang auszulösen von der ersten Konfiguration zu der zweiten Konfiguration und in den gegebenen Funktionsmodus, in dem die Schaltung anschließend dazu ausgelegt ist, eine oder mehrere Phasen in der ersten Konfiguration und eine oder mehrere Phasen in der zweiten Konfiguration zu alternieren.

3. Schaltung nach einem der Ansprüche 1 oder 2, bei der das zweite Steuersignal (V_{SR}) einen logischen Zustand hat, der von jenem eines Indikatorsignals (T_{OFF}) der ersten Konfiguration abhängt, erzeugt durch den Logiksteuerblock (320), wobei das erste Steuersignal (V_{MS}) einen logischen Zustand hat, der von jenem eines Indikatorsignals (T_{ON}) der zweiten Konfiguration abhängt, erzeugt durch den Logiksteuerblock (320) und komplementär zu dem Indikatorsignal (T_{OFF}) der ersten Konfiguration, wobei der Steuerblock dazu ausgelegt ist, das Indikatorsignal (T_{ON}) der zweiten Konfiguration im Anschluss an einen Empfang des Auslösesignals (V_{boost}) zu modifizieren (320), wobei die Phase(n) in der zweiten Konfiguration eine feste Dauer D_TON hat/haben, an deren Ende der Steuerblock (320) automatisch das Indikatorsignal (T_{ON}) der zweiten Konfiguration modifiziert, wobei die Phase(n) in der ersten Konfiguration eine vorbestimmte maximale Dauer D_TOFFmax hat/haben, die durch den Steuerblock gesteuert wird und höchstens gleich der festen Dauer D_TON vorgesehen ist/sind.

4. Schaltung nach Anspruch 3, bei der die feste Dauer D_TON und die vorbestimmte maximale Dauer D_TOFFmax derart sind, dass: L/2Rs ≤ D_TON ≤ L/Rs.

5. Schaltung nach einem der Ansprüche 3 oder 4, die ferner ausgestattet ist mit einem ersten Block (290) zur Anzeige des Ablaufs der Dauer D_TON der zweiten Konfiguration, um nach einer Zustandsänderung des zweiten Indikatorsignals (T_{ON}) nach einer vorbestimmten Verzögerung gleich der festen Dauer D_TON ein Ablaufindikatorsignal (T_{OND}) der Dauer der zweiten Konfiguration mit Bestimmung für den Steuerblock (320) derart zu generieren, dass eine Zustandsänderung des Indikatorsignals (T_{ON}) der zweiten Konfiguration ausgelöst wird.

6. Schaltung nach einem der Ansprüche 3 bis 5, die ferner ausgestattet ist mit: einem Block (300) zur Anzeige des Ablaufs der maximalen Dauer D_TOFF der ersten Konfiguration, um nach einer Zustandsänderung des Indikatorsignals (T_{OFF}) der ersten Konfiguration nach einer vorbestimmten Verzögerung ein Ablaufsignal (T_{OFFD}) von maximaler Dauer der ersten Konfiguration mit Bestimmung für den Steuerblock (320) zu generieren, das dazu ausgelegt ist, eine Zustandsänderung des Indikatorsignals (T_{OFF}) der ersten Konfiguration auszulösen.

7. Schaltung nach einem der Ansprüche 1 bis 6, ferner umfassend: eine Stufe (280) zur Detektion von minimalem Strom, insbesondere ausgestattet mit einem Stromkomparator (281), zum Detektieren eines Stroms (I_{SENSE}), der dazu ausgelegt ist, am Eingang der Ladestufe geliefert zu werden und in das Speichermittel (Cₜₐₙₖ) für Ladungen injiziert zu werden, und wenn der am Eingang der Ladestufe geliefert Strom unter eine Schwelle (I_{refmin}) passiert, als Konsequenz ein Detektionssignal für minimalen Strom (V_{IMIN}) mit Bestimmung für den Steuerblock (320) zu generieren, das dazu ausgelegt ist, eine Konfigurationsänderung von der ersten Konfiguration zur zweiten Konfiguration auszulösen.

8. Schaltung nach einem der Ansprüche 1 bis 7, die ferner ausgestattet ist mit einer Stufe (270) zu Detektion eines minimalen Ausgangsspannungswerts, insbesondere versehen mit einem Schwellendetektor (271), der dazu konfiguriert ist, einen Übergang der Ausgangsspannung (V_{OUT}), die an das Speichermittel (130) für elektrische Ladungen angelegt ist, über einen Schwellenwert hinaus zu detektieren und, wenn diese Detektion realisiert ist, einen Logikzustand von einem ersten Zustand zu einem zweiten Zustand eines Schwellendetektionssignals (Vₚₒᵣ) mit Bestimmung für den Logiksteuerblock (320) zu modifizieren, wobei der Logiksteuerblock (320) dazu konfiguriert ist, das Auslösen eines Übergangs von der ersten Konfiguration zur zweiten Konfiguration bei der Zustandsmodifikation des Schwellendetektionssignals (Vₚₒᵣ) zu konditionieren.

9. Schaltung nach Anspruch 8, wobei der Logiksteuerblock (320) dazu konfiguriert ist, den Übergang von der zweiten Konfiguration zur ersten Konfiguration im Anschluss an eine Zustandsänderung des zweiten Zustands zum ersten Zustand des Schwellendetektionssignals (Vₚₒᵣ) auszulösen.

10. Schaltung nach einem der Ansprüche 1 bis 9, die ferner ausgestattet ist mit einer anderen Detektionsstufe (315), die mit einem Komparator (316) versehen ist, die dazu konfiguriert ist, die Ausgangsspannung (V_{OUT}), die an das Speichermittel (130) für elektrische Ladungen angelegt ist, und die Spannung (V_{NVC}) am Ausgang des Gleichrichters zu vergleichen, und ein Vergleichssignal (V_{UP}=1) zu erzeugen, das einen Zustand hat, der angibt, ob die Spannung (V_{NVC}) am Ausgang des Gleichrichters größer ist als die Ausgangsspannung (V_{OUT}), die an das Speichermittel (130) angelegt ist, wobei der Steuerblock (320) dazu konfiguriert ist, das Schließen des ersten Unterbrechers (260) bei einer Versetzung des Vergleichssignals (V_{UP}) in einen gegebenen Zustand zu konditionieren.

11. Schaltung nach einem der Ansprüche 1 bis 10, ferner umfassend eine Stufe (230) zur Detektion von Überspannungen der Spannung (V_{OUT}) an den Anschlüssen des Mittels (Cₜₐₙₖ) zur Speicherung von Ladungen, wobei die Überspannungsdetektionsstufe (230) ausgestattet ist mit einem Komparator (231), der dazu konfiguriert ist, die Spannung (V_{OUT}) an den Anschlüssen des Mittels zur Speicherung von Ladungen mit einer vorbestimmten Schwellenspannung (V_{OVTH}) zu vergleichen, und ein Überspannungsdetektionssignal (Vov) zu erzeugen, wenn die vorbestimmte Schwellenspannung überschritten wird, wobei der Steuerblock (320) ferner dazu konfiguriert ist, im Anschluss an den Empfang des Überspannungsdetektionssignals (Vov) eine Zustandsänderung des zweiten Steuersignals (V_{SR}) derart auszulösen, dass der zweite Unterbrecher (240) geöffnet wird, wobei der Empfang des Überspannungsdetektionssignals (Vov) ferner dazu ausgelegt ist, eine Zustandsänderung des ersten Steuersignals (V_{MS}) derart auszulösen, dass der erste Unterbrecher (260) geschlossen wird.

12. Schaltung nach Anspruch 11, bei der der zweite Unterbrecher (240) einen Entladungstransistor (241) umfasst, der eine Wannenregion umfasst, wobei die Vorrichtung ferner eine Schaltung (220) zur Selektion des Potentials der Wanne umfasst, die dazu konfiguriert ist, im Anschluss an den Empfang des Überspannungsdetektionssignals (Vov) ein gegebenes Potential zu selektionieren, das größte zwischen einer Spannung (V_{NVC}) am Ausgang des Gleichrichters, angelegt an einen Anschluss des Entladungstransistors (241) und der Spannung (V_{OUT}) an den Anschlüssen des Mittels zur Speicherung von Ladungen, und das selektionierte gegebene Potential an die Wannenregion anzulegen.

13. Schaltung nach einem der Ansprüche 1 bis 12, bei der das Mittel (130) zur Speicherung von elektrischen Ladungen dazu ausgelegt ist, einem RF-Sender (140) zugeordnet zu sein, der dazu vorgesehen ist, ein RF-Signal als Funktion der Füllung des Mittels zur Speicherung von elektrischen Ladungen zu senden.

14. Schaltung nach einem der Ansprüche 1 bis 13, bei der der erste Unterbrecher mit einem Transistor (261) gebildet ist, der eine Elektrode umfasst, die direkt an den ersten Anschluss (P1) angeschlossen ist und eine Elektrode, die direkt an den zweiten Anschluss (M1) angeschlossen ist.

15. Drahtloses Unterbrechersystem, umfassend:
- eine Stufe zur Wiedergewinnung von elektromagnetischer Energie,
- eine elektronische Schnittstellenschaltung nach einem der vorhergehenden Ansprüche, die am Ausgang der Stufe zur Wiedergewinnung von elektromagnetischer Energie angeordnet ist,
- eine Ladestufe am Ausgang der elektronischen Schnittstellenschaltung, wobei die Ladestufe ausgestattet ist mit einem Mittel (130) zur Speicherung von elektrischen Ladungen, und mit einem RF-Sender (140), der dazu vorgesehen ist, ein RF-Signal als Funktion der Füllung des Mittels (Cₜₐₙₖ) zur Speicherung von elektrischen Ladungen zu senden.

## Claims

1. An electronic interface circuit (120) for electromagnetic energy harvesting, to be disposed between an electromagnetic energy harvesting stage (110) and a load stage (130-140), the electromagnetic energy harvesting stage having an equivalent electrical circuit provided in series with an alternating voltage generator (101), an inductance L and an output impedance (Rs), the generator producing an alternating AC signal resulting from a conversion of mechanical energy into electromagnetic energy, the load stage (130-140) being provided with a means (130) for storing electrical charges, particularly a capacitance,
said electronic interface circuit comprising:
- an AC/DC converter configured for converting an input signal between a first terminal (P1) and a second terminal (M1) connected at the output of said harvesting stage, and producing a DC signal at the input of the load stage, the converter being provided with a rectifier for producing a rectified signal to said means for storing electrical charges,
- a first switch (260), arranged between the first terminal and the second terminal and capable of alternately connecting or disconnecting the first terminal and the second terminal from one another, the closed or open state of the first switch (260) being governed by a first command signal,
- a second switch (240), disposed between an output of the rectifier and the load stage and capable of alternately connecting or disconnecting the output of the rectifier from said load stage, the open or closed state of the second switch being governed by a second command signal,
the electronic interface circuit being further provided with a logic control block configured to produce said first command signal and said second command signal, the control block being capable of alternately switching said switches from a first configuration to a second configuration and from the second to the first configuration,
the first configuration being a configuration wherein the first switch (260) is open and the second switch is closed, so that said first terminal and said second terminal are disconnected and the output of said rectifier is connected to said means for storing electrical charges,
the second configuration being a configuration wherein the first switch (260) is closed and the second switch is open so as to disconnect the output of the rectifier from said load stage and connect the first terminal and the second terminal to each other,
said logic control block being further configured, in an operating "linear mode" of said circuit, to put the switches in said first configuration,
said logic control block being further configured, in a given operating "boost mode" of said circuit, to trigger an alternation between said first configuration and said second configuration several times,
said logic control block (320) being further configured, to trigger a switch from the linear mode toward said given operating mode consecutively to an output voltage (VOUT)(Vout) of the means for storing electrical charges being higher than a threshold value.

2. The circuit according to claim 1, further comprising an operating mode detection stage (310) provided with a comparator (311) for comparing an output voltage (V_{OUT}) applied to said charge storage means with a voltage equal to a product Rₘᵢₙ^{∗}Iₛₑₙₛₑ of a current Iₛₑₙₛₑ supplied at the output of said rectifier and capable of being injected into said charge storage means by a resistance Rₘᵢₙ of a predetermined value and which depends on the output impedance value Rₛ of said electromagnetic energy harvesting stage, particularly so that Rₘᵢₙ = K^{∗}Rs, K being a real number, and generating when this product is less than the output voltage, a trigger signal to said logic control block and capable of triggering a switching from the first configuration to said second configuration and in said given operating mode wherein the circuit is then capable of alternating one or more phase(s) in said first configuration and one or more phase(s) in said second configuration.

3. The circuit according to any if the claims 1 or 2, wherein the second command signal (V_{SR}) has a logic state which depends on that of a first configuration indicator signal (T_{OFF}) produced by said logic control block, the first command signal (V_{MS}) has a logic state depending on that of a second configuration indicator signal produced by said logic control block and complementary to the first configuration indicator signal (T_{OFF}), the control block (320) being capable of modifying said second configuration indicator signal subsequently to a reception of said trigger signal , the phase(s) in said second configuration having a fixed duration D_TON at the end of which said control block automatically modifies the second configuration indicator signal (T_{ON}), the phase(s) in said first configuration having a predetermined maximum duration D_TOFFmax controlled by the control block and provided at most equal to the fixed duration D_TON.

4. The circuit according to claim 3, wherein the fixed duration D_TON and the predetermined maximum duration D_TOFFmax are such that: L/2Rs ≤ D_TON ≤ L/Rs.

5. The circuit according to any of the claims 3 or 4, further provided with a first block (290) indicating the duration D_TON lapse of a second configuration for, after a change of state of said second indicator signal (T_{ON}), generating after a predetermined delay equal to said fixed duration D_TON , a signal indicating the duration lapse of the second configuration to the control block so as to trigger a change of state of said second configuration indicator signal (T_{ON}).

6. The circuit according to any of the claims 3 to 5, further provided with: a block (300) indicating the maximum duration D_TOFF lapse of the first configuration for, after a change of state of said first configuration indicator signal (T_{OFF}), generating after a predetermined delay a signal (T_{OFFD}) of maximum duration lapse of the first configuration to the control block (320) capable of triggering a change of state of the first configuration indicator signal (T_{OFF}).

7. The circuit according to any of the claims 1 to 6, further comprising: a minimum current detection stage (280), particularly provided with a current comparator, for detecting a current capable of being supplied at the input of said load stage and being injected into said charge storage means and when said current supplied at the input of said load stage falls below a threshold, consequently generating a minimum current detection signal to the control block capable of triggering a change of configuration from the first configuration to the second configuration.

8. The circuit according to any of the claims 1 to 7, further provided with a stage (270) for detecting a minimum output voltage value, particularly provided with a threshold detector (271), configured to detect a passage of the output voltage (VOUT) applied to the means for storing electrical charges (130) above a threshold value and modify, when this detection is carried out, a logic state from a first state to a second state of a threshold detection signal (Vₚₒᵣ) to the logic control block (320), said logic control block being configured to condition the triggering of a switching from the first configuration to the second configuration upon said state modification of said threshold detection signal (Vₚₒᵣ).

9. The circuit according to claim 8, said logic control block (320) being configured to trigger the switching from the second configuration to the first configuration subsequently to a change of state from the second state to the first state of said threshold detection signal (Vₚₒᵣ).

10. The circuit according to any of the claims 1 to 9, further provided with another detection stage provided with a comparator, configured to compare the output voltage (VOUT) applied to the means for storing electrical charges and the voltage at the output of the rectifier, and produce a comparison signal having a state indicating whether the voltage at the output of the rectifier is greater than the output voltage (VOUT) applied to the storage means, the control block being configured to condition the closing of the first switch (260) to a setting in a given state of said comparison signal.

11. The circuit according to any of the claims 1 to 10, further comprising a stage (230) for detecting overvoltages of said voltage at the terminals of said charge storage means, the overvoltage detection stage being provided with a comparator configured to compare said voltage (V_{OUT}) at the terminals of said charge storage means with a predetermined threshold voltage (V_{OVTH}), and produce an overvoltage detection signal when the predetermined threshold voltage is exceeded, the control block (320) being further configured, subsequently to the reception of said overvoltage detection signal, to trigger a change of state of said second command signal (V_{SR}) so as to open the second switch (240), the reception of said overvoltage detection signal (Vov) being further capable of triggering a change of state of said first command signal (V_{MS}) so as to close the first switch (260).

12. The circuit according to claim 11, wherein the second switch (240) comprises a discharge transistor (241) including a bulk region, the device further comprising a bulk potential selection circuit (220) configured, subsequently to the reception of said overvoltage detection signal (Vov), to select a given potential, the highest between a voltage (V_{NVC}) at the output of the rectifier applied to a terminal of said discharge transistor and said voltage (V_{OUT}) at the terminals of said charge storage means, and apply the selected given potential to said bulk region.

13. The circuit according to any of the claims 1 to 12, wherein the means for storing electrical charges (130) is capable of being associated with an RF emitter (140) provided for emitting an RF signal according to the filling of said means for storing electrical charges.

14. The circuit according to any of the claims 1 to 13, wherein the first switch (260) is formed of a transistor (261) including an electrode directly connected to said first terminal (P1) and an electrode directly connected to the second terminal (M1).

15. A wireless switch system, comprising:
- an electromagnetic energy harvesting stage,
- an electronic interface circuit according to one of the preceding claims arranged at the output of the electromagnetic energy harvesting stage,
a load stage at the output of said electronic interface circuit, the load stage being provided with a means for storing electrical charges (130) and with an RF emitter (140) provided for emitting an RF signal according to the filling of said means for storing electrical charges (Cₜₐₙₖ).
